# EUROPEAN PATENT APPLICATION

(11) **EP 4 704 514 A2**
(43) Date of publication of application: **04.03.2026**
(21) Application number: 25195207.3
(22) Date of filing: 11.08.2025
(51) Int. Cl.: H10D 1/68, H10D 84/00, H04B 1/00

(54) **CAPACITOR STRUCTURE, AND CAPACITOR ARRAY AND ELECTRONIC DEVICE INCLUDING THE SAME**

(30) Priority: 29.08.2024 KR 20240116672; 03.12.2024 KR 20240177302
(71) Applicant: Samsung Electronics Co., Ltd., Suwon-si, Gyeonggi-do 16677 (KR)
(72) Inventor: JUNG, Wonjun, 16677 Suwon-si (KR); KIM, Sinyoung, 16677 Suwon-si (KR); SEOK, Hyungi, 16677 Suwon-si (KR)
(74) Representative: Marks & Clerk LLP

(57) **Abstract**

A capacitor structure includes a semiconductor substrate, a first well, a second well, a first electrode, a second electrode, a first choke impedance element and a second choke impedance element. The semiconductor substrate includes an outer well having a first conductivity type. The first well is disposed in the outer well and has a second conductivity type. The second well is disposed in the first well and has the first conductivity type. At least portions of the first and second electrodes contact the second well. The first choke impedance element is connected between the second well and a ground voltage. The second choke impedance element is connected between the first well and a power supply voltage.

## Description

### BACKGROUND

### 1. Field

Example embodiments relate generally to semiconductor integrated circuits, and more particularly to capacitor structures, switch structures, and capacitor arrays and electronic devices including the capacitor structures and/or switch structures.

### 2. Description of Related Art

With the increase in package price, the chip size of a radio frequency integrated circuit (RFIC) for wireless mobile communication has been increasingly reduced. In addition, it is beneficial for RFICs for wireless mobile communication to produce a desired output with low power. Recently, as mobile communication has evolved from third-generation (3G) to long-term evolution (LTE) to fifth-generation (5G), RFICs for wireless mobile communications are increasingly required to support modulations such as radio detecting and ranging (RADAR), and their operating frequencies are also increasing. However, there are problems in the design of an impedance matching network of RFICs for wireless mobile communications, and in the design of RFICs for wireless mobile communications with low noise characteristics.

In RFICs for ultra wideband (UWB) RADAR used in wireless mobile communications and vehicles, the demand for supporting wide bandwidth is increasing, and high output power is also required. Therefore, research is being conducted to address these problems.

### SUMMARY

One or more example embodiments provide a capacitor structure and a switch structure that may have a relatively low parasitic capacitance.

Further, one or more example embodiments provide a capacitor array including the capacitor structure and/or the switch structure that may have improved reliability and improved performance.

Further, one or more example embodiments provide an electronic device including the capacitor structure, the switch structure and/or the capacitor array.

According to an aspect of an example embodiment, a capacitor structure includes: a semiconductor substrate including an outer well having a first conductivity type; a first well in the outer well and having a second conductivity type; a second well in the first well and having the first conductivity type; a first electrode and a second electrode, at least portions of the first electrode and the second electrode being on the second well; a first choke impedance element connected between the second well and a ground voltage; and a second choke impedance element connected between the first well and a power supply voltage.

According to an aspect of an example embodiment, a capacitor array includes: a plurality of capacitors connected between a first terminal and a second terminal; and at least one switch between two adjacent capacitors among the plurality of capacitors, wherein each capacitor of the plurality of capacitors includes: an outer well having a first conductivity type; a first well in the outer well and having a second conductivity type; a second well in the first well and having the first conductivity type; and a first electrode and a second electrode, at least portions of the first electrode and the second electrode on the second well, and wherein the second well of each capacitor of the plurality of capacitors is electrically isolated from other second wells of other capacitors of the plurality of capacitors.

According to an aspect of an example embodiment, a capacitor array includes: a plurality of capacitors connected between a first terminal and a second terminal; and at least one switch between two adjacent capacitors among the plurality of capacitors, wherein the at least one switch includes: a plurality of transistors connected in series between a third terminal and a fourth terminal, each of the plurality of transistors including a gate electrode receiving a first switch control signal, the third terminal and the fourth terminal being between the two adjacent capacitors; a plurality of first resistors, each of the plurality of first resistors being connected to the third terminal, the fourth terminal or a node between two adjacent transistors among the plurality of transistors, a second switch control signal being applied to each of the plurality of first resistors; a plurality of second resistors, each of the plurality of second resistors being connected between the gate electrode of one of the plurality of transistors and the first switch control signal; and a plurality of choke impedance elements, each of the plurality of choke impedance elements being connected between a body of one of the plurality of transistors and a ground voltage.

According to an aspect of an example embodiment, an electronic device includes: at least one capacitor, wherein the at least one capacitor includes: a semiconductor substrate including an outer well having a first conductivity type; a first well in the outer well and having a second conductivity type; a second well in the first well and having the first conductivity type; a first electrode and a second electrode, at least portions of the first electrode and the second electrode contacting the second well; a first choke impedance element connected between the second well and a ground voltage; and a second choke impedance element connected between the first well and a power supply voltage.

According to an aspect of an example embodiment, a switch structure configured to control an electrical connection between a first terminal and a second terminal, includes: a plurality of transistors connected in series between the first terminal and the second terminal, each of the plurality of transistors including a gate electrode receiving a first switch control signal; a plurality of first resistors, each of the plurality of first resistors being connected to the first terminal, the second terminal or a node between two adjacent transistors among the plurality of transistors, a second switch control signal being applied to each of the plurality of first resistors; a plurality of second resistors, each of the plurality of second resistors being connected between the gate electrode of a transistor of the plurality of transistors and the first switch control signal; and a plurality of choke impedance elements, each of the plurality of choke impedance elements being connected between a body of a transistor of the plurality of transistors and a ground voltage.

Bodies of the plurality of transistors may be electrically isolated or separated by the plurality of choke impedance elements.

The plurality of choke impedance elements may be configured to reduce a parasitic capacitance of the switch structure.

Each of the plurality of choke impedance elements may include a choke resistor.

The plurality of transistors may include a first transistor, a second transistor and a third transistor that are connected in series between the first terminal and the second terminal.

The plurality of first resistors may include: a first-first resistor connected between the first terminal and the second switch control signal; a first-second resistor connected between a first node and the second switch control signal, the first node being between the first transistor and the second transistor; a first-third resistor connected between a second node and the second switch control signal, the second node being between the second transistor and the third transistor; and a first-fourth resistor connected between the second terminal and the second switch control signal.

The plurality of second resistors may include: a second-first resistor connected between a gate electrode of the first transistor and the first switch control signal; a second-second resistor connected between a gate electrode of the second transistor and the first switch control signal; and a second-third resistor connected between a gate electrode of the third transistor and the first switch control signal.

The plurality of choke impedance elements may include: a first choke resistor connected between a body of the first transistor and the ground voltage; a second choke resistor connected between a body of the second transistor and the ground voltage; and a third choke resistor connected between a body of the third transistor and the ground voltage.

A thickness of an insulating layer between the gate electrode of each of the plurality of transistors and a semiconductor substrate may be less than a reference thickness.

Each of the plurality of transistors may be an n-type metal oxide semiconductor transistor.

The capacitor structure according to example embodiments may be implemented with the triple well structure, may include the first choke impedance element connected between the second well (e.g., the first and second impurity regions) and the ground voltage, and may include the second choke impedance element connected between the first well (e.g., the fourth impurity region) and the power supply voltage. Accordingly, the parasitic capacitance may be reduced, and operating performance and characteristics may be improved.

The switch structure according to example embodiments may be implemented with the stacked transistor structure, and may include the plurality of choke impedance elements connected between the plurality of transistors and the ground voltage. Accordingly, the parasitic capacitance may be reduced, and the operating performance and characteristics may be improved.

The capacitor array and the electronic device according to example embodiments may include the capacitor structure and/or the switch structure, and thus the parasitic capacitance may be reduced and the wide frequency tuning range may be obtained. Accordingly, the insertion loss may be reduced, the wide frequency range may be supported, and the reliability may be improved.

At least some of the above and other features of the invention are set out in the claims.

### BRIEF DESCRIPTION OF THE DRAWINGS

Illustrative, non-limiting example embodiments will be more clearly understood from the following detailed description taken in conjunction with the accompanying drawings, in which:
FIG. 1 is a diagram illustrating a capacitor structure according to example embodiments;
FIG. 2 is a diagram illustrating an example of a capacitor structure of FIG. 1;
FIGS. 3 and 4 are diagrams for describing a capacitor structure of FIG. 2;
FIGS. 5A, 5B and 5C are diagrams for describing characteristics of a capacitor structure of FIG. 2;
FIGS. 6A, 6B and 6C are diagrams illustrating examples of first and second electrodes included in a capacitor structure of FIG. 2;
FIG. 7 is a diagram illustrating an example of a capacitor structure of FIG. 1;
FIG. 8 is a diagram illustrating a switch structure according to example embodiments;
FIG. 9 is a circuit diagram illustrating an example of a switch structure of FIG. 8;
FIGS. 10A, 10B, 10C, 10D, 10E, 11A and 11B are diagrams for describing a switch structure of FIG. 9;
FIGS. 12A and 12B are diagrams illustrating examples of a transistor included in a switch structure of FIG. 9;
FIGS. 13, 14 and 15 are block diagrams illustrating a capacitor array according to example embodiments;
FIG. 16 is a circuit diagram illustrating an example of a capacitor array of FIG. 15;
FIGS. 17A, 17B, 17C and 17D are diagrams for describing an operation of a capacitor array of FIG. 16;
FIGS. 18, 19 and 20 are block diagrams illustrating an electronic device according to example embodiments;
FIGS. 21 and 22 are block diagrams illustrating examples of an electronic device of FIG. 20;
FIG. 23 is a block diagram illustrating an electronic device in a network environment according to example embodiments.

### DETAILED DESCRIPTION

Various example embodiments will be described more fully with reference to the accompanying drawings, in which embodiments are shown. The present disclosure may, however, be embodied in many different forms and should not be construed as limited to the embodiments set forth herein. Like reference numerals refer to like elements throughout this application.

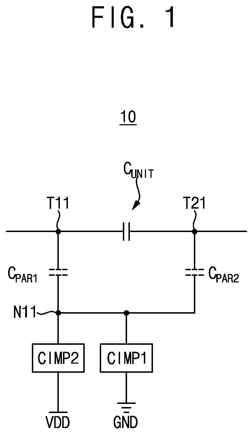

FIG. 1 is a diagram illustrating a capacitor structure according to example embodiments.

Referring to FIG. 1, a capacitor structure 10 includes a capacitor element C_{UNIT}, a first choke impedance element CIMP1 and a second choke impedance element CIMP2. The choke impedance elements may include discrete inductor elements such as wire wound on a core, or may be a planar-circuit configuration using radial stub design.

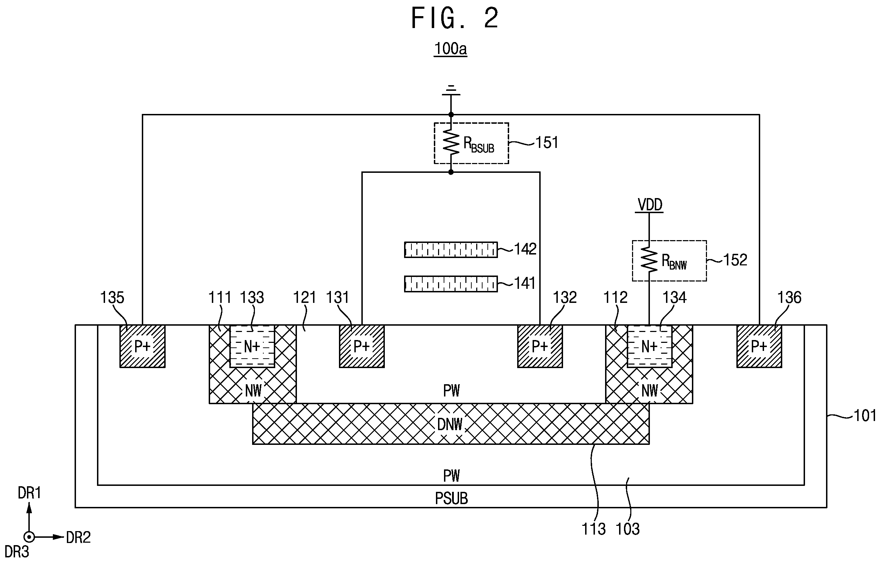

In some example embodiments, the capacitor structure 10 may be manufactured using a semiconductor process, and may further include various components disposed (or arranged) and/or formed in and/or on a semiconductor substrate, in addition to the capacitor element C_{UNIT}, the first choke impedance element CIMP1 and the second choke impedance element CIMP2. Example configurations of the capacitor structure 10 will be described with reference to FIGS. 2 through 7.

The capacitor element C_{UNIT} is connected between a first terminal T11 and a second terminal T21. The capacitor element C_{UNIT} may include a first plate connected to the first terminal T11, and a second plate connected to the second terminal T21. The capacitor element C_{UNIT} may further include a dielectric material disposed and/or formed between the first plate and the second plate.

The capacitor structure 10 may be manufactured and/or modeled to include a first parasitic capacitor C_{PAR1} and a second parasitic capacitor C_{PAR2}. For example, the first parasitic capacitor C_{PAR1} may be connected between the first terminal T11 and a node N11, and the second parasitic capacitor C_{PAR2} may be connected between the second terminal T21 and the node N11. The first and second parasitic capacitors C_{PAR1} and C_{PAR2} may not be included in real products (e.g., may not actually exist as unit elements in real products), and may be or represent parasitic components. In FIG. 1 and the subsequent figures, components corresponding to parasitic components are illustrated by dotted lines.

In some example embodiments, when the capacitor structure 10 is manufactured using the semiconductor process, the first and second parasitic capacitors C_{PAR1} and C_{PAR2} may be formed between the semiconductor substrate and at least one of the first and second plates of the capacitor element C_{UNIT}.

The first choke impedance element CIMP1 is connected between the node N11 and a ground voltage GND, and the second choke impedance element CIMP2 is connected between the node N11 and a power supply voltage VDD. In FIG. 1 and the subsequent figures, three parallel straight lines with different lengths may represent the ground voltage GND.

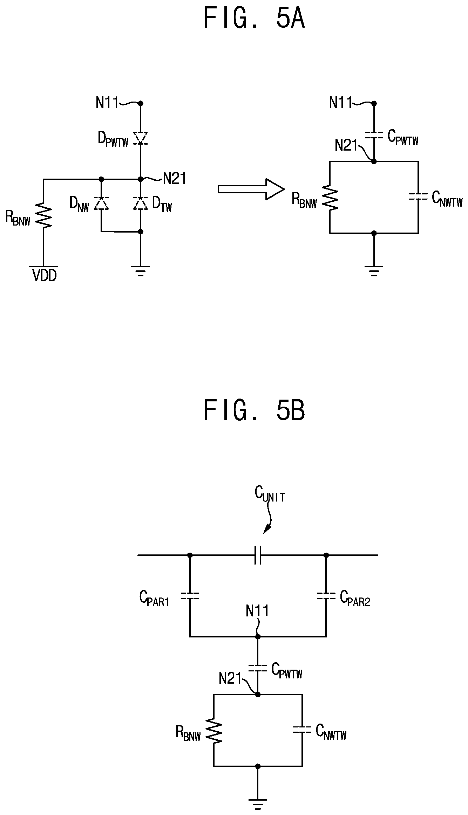

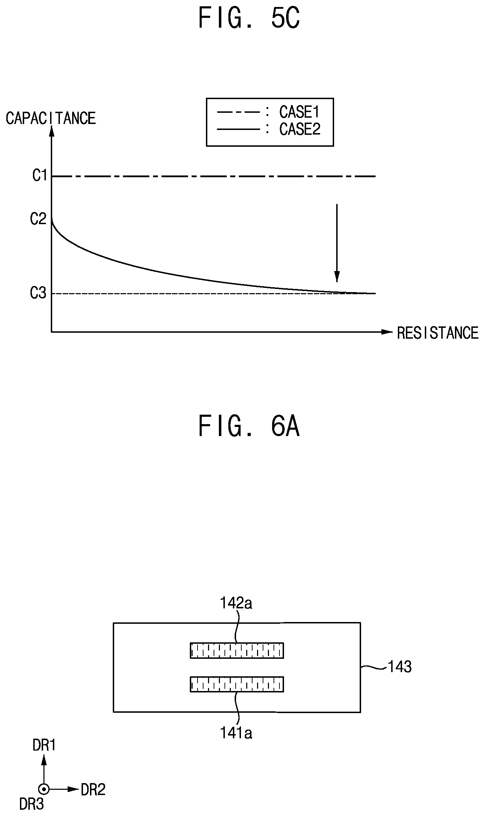

When the first and second choke impedance elements CIMP1 and CIMP2 are included in and connected to the capacitor structure 10, a parasitic capacitance of the capacitor structure 10 may be reduced, which will be described with reference to FIGS. 5A, 5B and 5C.

In some example embodiments, each of the first and second choke impedance elements CIMP1 and CIMP2 may be implemented to have a relatively high impedance.

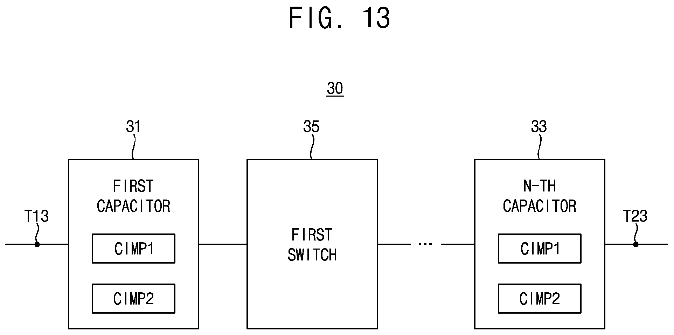

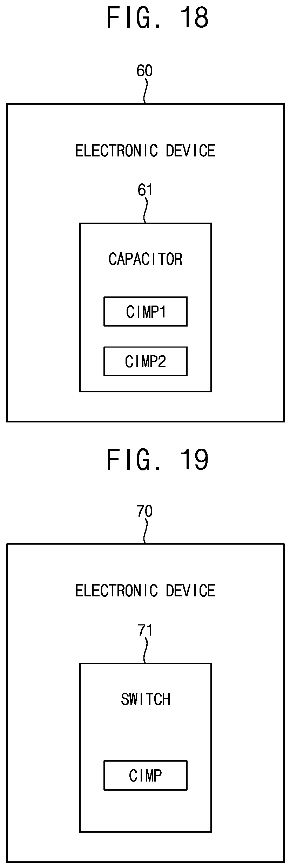

In some example embodiments, the capacitor structure 10 may be included in various electronic devices that operate based on a relatively high operating frequency, and for example, may be included in an electronic device that performs a frequency tuning operation by adjusting a capacitance. For example, the capacitor structure 10 may be included in a capacitor array for performing and supporting the frequency tuning operation and for obtaining a relatively wide frequency tuning range. The capacitor array will be described with reference to FIGS. 13 through 17D, and the electronic device will be described with reference to FIGS. 18 through 23.

FIG. 2 is a diagram illustrating an example of a capacitor structure of FIG. 1.

Referring to FIG. 2, a capacitor structure 100a includes a semiconductor substrate 101, an outer well 103, a first well 111, 112 and 113, a second well 121, a first electrode 141, a second electrode 142, a first choke impedance element 151 and a second choke impedance element 152. The capacitor structure 100a may further include a first impurity region 131, a second impurity region 132, a third impurity region 133, a fourth impurity region 134, a fifth impurity region 135 and a sixth impurity region 136.

In FIG. 2 and the subsequent figures, a direction vertical or substantially vertical to a first surface (e.g., an upper surface or a top surface) of the semiconductor substrate 101 is referred to as a first direction DR1 (e.g., a Z-axis direction). In addition, two directions that are each parallel or substantially parallel to the first surface of the semiconductor substrate 101 and crossing each other are referred to as a second direction DR2 (e.g., a X-axis direction) and a third direction DR3 (e.g., a Y-axis direction). For example, the second and third directions DR2 and DR3 may be perpendicular or substantially perpendicular to each other. In addition, the first direction DR1 may be perpendicular or substantially perpendicular to both the second and third directions DR2 and DR3. Further, a direction indicated by an arrow in the figures and a reverse direction thereof are considered as the same direction.

The semiconductor substrate 101 has a first conductivity type. The outer well 103 is disposed and/or formed in the semiconductor substrate 101, and has the first conductivity type. The first well 111, 112 and 113 is disposed and/or formed in the outer well 103, and has a second conductivity type different from the first conductivity type. The second well 121 is disposed and/or formed in the first well 111, 112 and 113, and has the first conductivity type.

In some example embodiments, the first conductivity type may be a p-type conductivity, and the second conductivity type may be an n-type conductivity. In this example, the semiconductor substrate 101 may correspond to a p-type substrate PSUB, the outer well 103 may correspond to a p-well PW, the first well 111, 112 and 113 may correspond to an n-well NW and DNW, and the second well 121 may correspond to a p-well PW.

In some example embodiments, a triple well structure may be implemented by the outer well 103, the first well 111, 112 and 113 and the second well 121. For example, when the outer well 103 corresponds to the p-well PW, when the first well 111, 112 and 113 corresponds to the n-well NW and DNW, and when the second well 121 corresponds to the p-well PW, a PNP triple well structure may be formed, but example embodiments are not limited thereto.

Hereinafter, example embodiments will be described based on that the first conductivity type is the p-type conductivity and the second conductivity type is the n-type conductivity. However, example embodiments are not limited thereto. In some example embodiments, the first conductivity type may be the n-type conductivity and the second conductivity type may be the p-type conductivity.

The first and second impurity regions 131 and 132 may be disposed and/or formed in the second well 121, and may have the first conductivity type. For example, in a cross-sectional view, the first and second impurity regions 131 and 132 may be spaced apart from each other along the second direction DR2 in the second well 121.

In some example embodiments, impurity concentrations of the first and second impurity regions 131 and 132 may be higher than an impurity concentration of the second well 121. For example, when the second well 121 corresponds to the p-well PW, each of the first and second impurity regions 131 and 132 may correspond to a p+ region.

The third and fourth impurity regions 133 and 134 may be disposed and/or formed in the first well 111, 112 and 113, and may have the second conductivity type. For example, in a cross-sectional view, the third and fourth impurity regions 133 and 134 may be spaced apart from each other along the second direction DR2 in the first well 111, 112 and 113.

In some example embodiments, impurity concentrations of the third and fourth impurity regions 133 and 134 may be higher than an impurity concentration of the first well 111, 112 and 113. For example, when the first well 111, 112 and 113 corresponds to the n-well NW and DNW, each of the third and fourth impurity regions 133 and 134 may correspond to an n+ region.

In some example embodiments, the first well 111, 112 and 113 may include a first well region 111, a second well region 112 and a third well region 113. The first well region 111 may surround the third impurity region 133, and may be in contact with a first side surface of the second well 121. The second well region 112 may surround the fourth impurity region 134, and may be in contact with a second side surface of the second well 121. The third well region 113 may be in contact with a lower surface of the second well 121. The outer well 103 and the second well 121 may be separated or isolated by the first well 111, 112 and 113.

In some example embodiments, the first and second well regions 111 and 112 may be in contact with the upper surface of the semiconductor substrate 101, and the third well region 113 may be spaced apart from the upper surface of the semiconductor substrate 101. For example, when the first well 111, 112 and 113 corresponds to the n-well NW and DNW, the first and second well regions 111 and 112 may correspond to normal n-wells NW, and the third well region 113 may correspond to a deep n-well DNW that is distinct from the normal n-wells NW.

Although the first and second well regions 111 and 112 are illustrated as individual components for convenience of illustration, example embodiments are not limited thereto. For example, the first and second well regions 111 and 112 may be integrally formed to surround the second well 121 in a plan view (or on a plane).

The fifth and sixth impurity regions 135 and 136 may be disposed and/or formed in the outer well 103, may have the first conductivity type, and may be connected to the ground voltage. For example, in a cross-sectional view, the fifth and sixth impurity regions 135 and 136 may be spaced apart from each other along the second direction DR2 in the outer well 103.

In some example embodiments, impurity concentration of the fifth and sixth impurity regions 135 and 136 may be higher than an impurity concentration of the outer well 103. For example, when the outer well 103 corresponds to the p-well PW, each of the fifth and sixth impurity regions 135 and 136 may correspond to a p+ region.

The first and second electrodes 141 and 142 are disposed and/or formed on the semiconductor substrate 101. For example, at least portions of the first and second electrodes 141 and 142 may be disposed and/or formed on the second well 121 between the first and second impurity regions 131 and 132. The first and second electrodes 141 and 142 may correspond to the first and second plates included in the capacitor element C_{UNIT} of FIG. 1, respectively. For example, the first and second electrodes 141 and 142 may be formed using a conductive layer (e.g., a metal layer) on the semiconductor substrate 101.

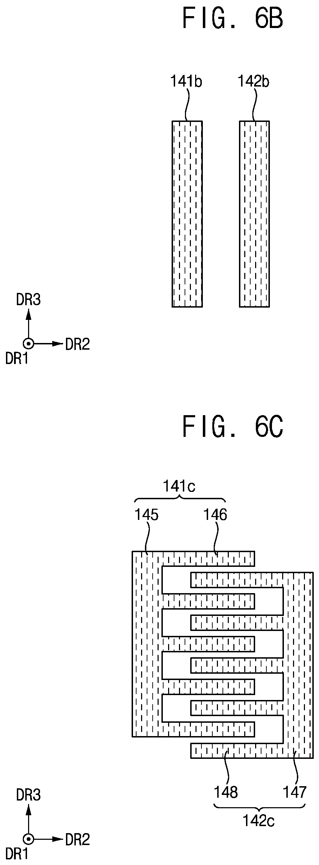

Although the first and second electrodes 141 and 142 are illustrated as stacked in the first direction DR1 for convenience of illustration, example embodiments are not limited thereto. Example configurations of the first and second electrodes 141 and 142 will be described later with reference to FIGS. 6A, 6B and 6C.

The first choke impedance element 151 is connected between the second well 121 and the ground voltage. For example, the first choke impedance element 151 may be connected between the first and second impurity regions 131 and 132 in the second well 121 and the ground voltage. Therefore, unlike the fifth and sixth impurity regions 135 and 136 which are directly connected to the ground voltage, the first and second impurity regions 131 and 132 may be connected to the ground voltage through the first choke impedance element 151.

The second choke impedance element 152 is connected between the first well 111, 112 and 113 and the power supply voltage VDD. For example, the second choke impedance element 152 may be connected between the fourth impurity region 134 in the first well 111, 112 and 113 and the power supply voltage VDD. Therefore, the fourth impurity region 134 may be connected to the power supply voltage VDD through the second choke impedance element 152. For example, the third impurity region 133 may be electrically floated, but the example embodiments are not limited thereto.

In some example embodiments, each of the first and second choke impedance elements 151 and 152 may include a choke resistor. For example, the first choke impedance element 151 may include a first choke resistor R_{BSUB} that is connected between the first and second impurity regions 131 and 132 and the ground voltage, and the second choke impedance element 152 may include a second choke resistor R_{BNW} that is connected between the fourth impurity region 134 and the power supply voltage VDD. For example, the first and second choke impedance elements 151 and 152 may have relatively high impedances using the first and second choke resistors R_{BSUB} and R_{BNW}, but example embodiments are not limited thereto.

In some example embodiments, when the first and second impurity regions 131 and 132 correspond to the p+ regions, and when the fourth impurity region 134 corresponds to the n+ regions, the first choke impedance element 151 connected to the p+ regions and the second choke impedance element 152 connected to the n+ region may be implemented separately.

In some example embodiments, the first and second choke impedance elements 151 and 152 may be disposed on the semiconductor substrate 101, and may be arranged outside the first well 111, 112 and 113 and the second well 121 in a plan view. However, example embodiments are not limited thereto.

Although FIG. 2 illustrates one capacitor structure 100a formed in and/or on the semiconductor substrate, example embodiments are not limited thereto, and a plurality of capacitor structures may be formed in and/or on the semiconductor substrate 101. For example, when the plurality of capacitor structures are formed in and/or on the semiconductor substrate 101, the plurality of capacitor structures may share the outer well 103. For example, the plurality of capacitor structures may be implemented by forming a plurality of first wells in one outer well and by forming each of a plurality of second wells in a respective one of the plurality of first wells.

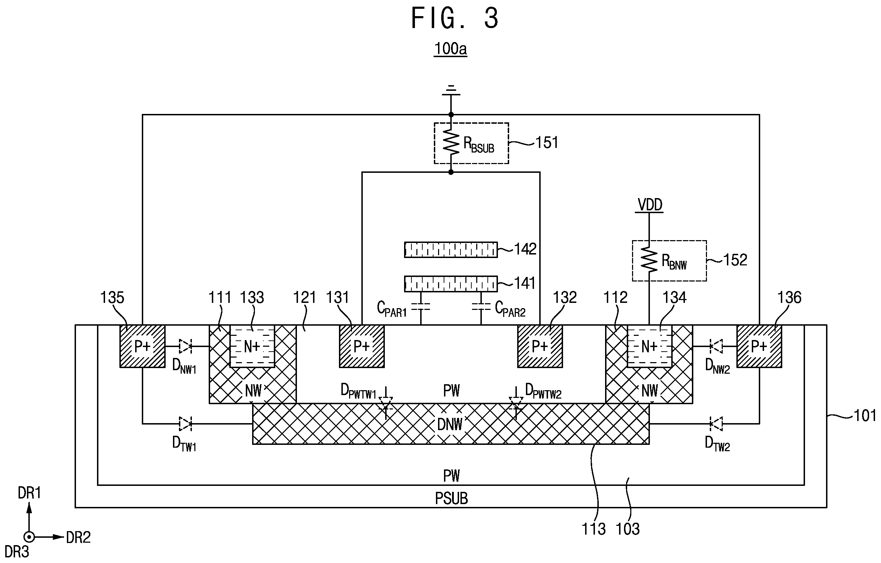

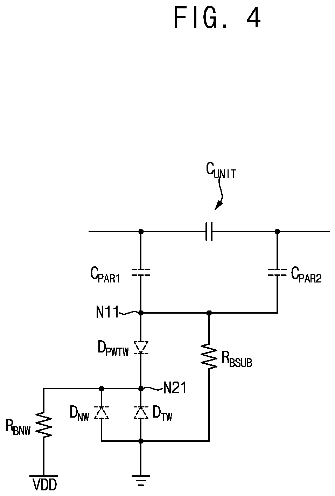

FIGS. 3 and 4 are diagrams for describing a capacitor structure of FIG. 2.

Referring to FIG. 3, an example of parasitic components occurred by the components in the capacitor structure 100a is illustrated.

The parasitic capacitors C_{PAR1} and C_{PAR2} described with reference to FIG. 1 may be formed between the second well 121 and at least one of the first and second electrodes 141 and 142.

Parasitic diodes D_{PWTW1} and D_{PWTW2} may be formed by a PN junction between the second well 121 and the third well region 113 among the first well 111, 112 and 113.

A parasitic diode D_{NW1} may be formed by a PN junction between the fifth impurity region 135 and the first well region 111 among the first well 111, 112 and 113. A parasitic diode D_{TW1} may be formed by a PN junction between the fifth impurity region 135 and the third well region 113 among the first well 111, 112 and 113.

A parasitic diode D_{NW2} may be formed by a PN junction between the sixth impurity region 136 and the second well region 112 among the first well 111, 112 and 113. A parasitic diode D_{TW2} may be formed by a PN junction between the sixth impurity region 136 and the third well region 113 among the first well 111, 112 and 113.

Referring to FIG. 4, an example of an equivalent circuit, which includes the capacitor element C_{UNIT} formed by first and second electrodes 141 and 142, the first and second choke resistors R_{BSUB} and R_{BNW} included in first and second choke impedance elements 151 and 152, and the parasitic components in FIG. 3, is illustrated.

The connections of the capacitor element C_{UNIT} and the parasitic capacitors C_{PAR1} and C_{PAR2} may be substantially the same as those described with reference to FIG. 1.

The first choke resistor R_{BSUB} may be connected between the node N11 and the ground voltage. A parasitic diode D_{PWTW} may be a parasitic component corresponding to the parasitic diodes D_{PWTW1} and D_{PWTW2} in FIG. 3, and may be connected between the node N11 and a node N21. A parasitic diode D_{TW} may be a parasitic component corresponding to the parasitic diodes D_{TW1} and D_{TW2} in FIG. 3, and may be connected between the node N21 and the ground voltage. A parasitic diode D_{NW} may be a parasitic component corresponding to the parasitic diodes D_{NW1} and D_{NW2} in FIG. 3, and may be connected in parallel with the parasitic diode D_{TW} between the node N21 and the ground voltage. The second choke resistor R_{BNW} may be connected between the node N21 and the power supply voltage VDD.

When the capacitor structure 100a has the configuration of the equivalent circuit illustrated in FIG. 4, a parasitic capacitance of the capacitor structure 100a may be reduced. For example, the parasitic capacitance of the capacitor structure 100a may be reduced depending on a resistance of the second choke resistor R_{BNW}.

FIGS. 5A, 5B and 5C are diagrams for describing characteristics of a capacitor structure of FIG. 2.

Referring to FIG. 5A, an example where a circuit on the left side including the second choke resistor R_{BNW} and the parasitic diodes D_{PWTW}, D_{TW} and D_{NW} of FIG. 4 is modeled to a circuit on the right side including the second choke resistor R_{BNW} and parasitic capacitors C_{PWTW} and C_{NWTW} is illustrated.

For example, the parasitic capacitor C_{PWTW} may correspond to a capacitor component of the parasitic diode D_{PWTW}, and the parasitic capacitor C_{NWTW} may correspond to a parallel connection of capacitor components of the parasitic diodes D_{TW} and D_{NW}. For example, the parasitic capacitor C_{PWTW} may be connected between the node N11 and the node N21, and the second choke resistor R_{BNW} and the parasitic capacitor C_{NWTW} may be connected in parallel between the node N21 and the ground voltage.

Referring to FIG. 5B, an example where a part including the first and second choke resistors R_{BSUB} and R_{BNW} and the parasitic diodes D_{PWTW}, D_{TW} and D_{NW} in the equivalent circuit of FIG. 4 is replaced with the modeled circuit on the right side of FIG. 5A, (e.g., the circuit including the second choke resistor R_{BNW} and the parasitic capacitors C_{PWTW} and C_{NWTW}) is illustrated.

Referring to FIG. 5C, an example where the parasitic capacitance is reduced in the circuit of FIG. 5B is illustrated.

In a graph of FIG. 5C, a horizontal axis represents the resistance of the second choke resistor R_{BNW}, and a vertical axis represents the parasitic capacitance of the capacitor structure. In addition, CASE1 represents a conventional capacitor structure that does not include the first and second choke resistors R_{BSUB} and R_{BNW}, and CASE2 represents the capacitor structure 100a according to example embodiments that includes the first and second choke resistors R_{BSUB} and R_{BNW}. Hereinafter, the capacitor and the corresponding capacitance will be described with the same reference numeral.

In the conventional capacitor structure that does not include the first and second choke resistors R_{BSUB} and R_{BNW}, the influence of the parasitic capacitors C_{PWTW} and C_{NWTW} may not be considered, and thus the parasitic capacitance may be determined only by the parasitic capacitors C_{PAR1} and C_{PAR2}. For example, in CASE1, a capacitance C1 may have a value corresponding to a parallel connection of the parasitic capacitors C_{PAR1} and C_{PAR2} (e.g., C1=C_{PAR1}+C_{PAR2}). For example, when C_{PAR1}=C_{PAR2}, C1=2*C_{PAR1}=2*C_{PAR2}. In addition, since the conventional capacitor structure does not include the first and second choke resistors R_{BSUB} and R_{BNW}, the parasitic capacitance may be constant regardless of the resistance of the second choke resistor R_{BNW}.

In the capacitor structure 100a according to example embodiments that includes the first and second choke resistors R_{BSUB} and R_{BNW}, the influence of the parasitic capacitors C_{PWTW} and C_{NWTW} may be considered by the second choke resistor R_{BNW}.

For example, even if the resistance of the second choke resistor R_{BNW} is very small, the influence of the parasitic capacitor C_{PWTW} may be considered, and the parasitic capacitance may be determined by the parasitic capacitors C_{PAR1} and C_{PAR2} and the parasitic capacitor C_{PWTW}. For example, in CASE2, when the resistance of the second choke resistor R_{BNW} is very small, a capacitance C2 may have a value corresponding to a series connection of the capacitance C1 and the parasitic capacitor C_{PWTW} (e.g., C2= C1 ∥ C_{PWTW}).

For example, as the resistance of the second choke resistor R_{BNW} increases, the influence of not only the parasitic capacitor C_{PWTW} but also the parasitic capacitor C_{NWTW} may be considered together, and the parasitic capacitance may be determined by the parasitic capacitors C_{PAR1} and C_{PAR2}, the parasitic capacitor C_{PWTW} and the parasitic capacitor C_{NWTW}. For example, in CASE2, when the resistance of the second choke resistor R_{BNW} is very large, a capacitance C3 may have a value corresponding to a series connection of the capacitance C2 and the parasitic capacitor C_{NWTW} (e.g., C3= C2 ∥ C_{NWTW}).

As described above, it can be seen that the parasitic capacitance of the capacitor structure 100a according to example embodiments that includes the first and second choke resistors R_{BSUB} and R_{BNW} is reduced, as compared with the conventional capacitor structure. For example, as the resistance of the second choke resistor R_{BNW} increases, the parasitic capacitance of the capacitor structure 100a may decrease.

FIGS. 6A, 6B and 6C are diagrams illustrating examples of first and second electrodes included in a capacitor structure of FIG. 2.

Referring to FIG. 6A, first and second electrodes 141a and 142a may be stacked in a direction (e.g., in the first direction DR1) perpendicular to the upper surface of the semiconductor substrate 101.

For example, first and second conductive layers, which are stacked in the first direction DR1, may be formed in an insulating layer 143. For example, the insulating layer 143 may include a plurality of insulating layers. Among the first and second conductive layers, the first conductive layer, which is a lower conductive layer, may include the first electrode 141a, and the second conductive layer, which is an upper conductive layer, may include the second electrode 142a. For example, the first and second electrodes 141a and 142a and the insulating layer 143 may be disposed and/or formed on the semiconductor substrate 101.

In some example embodiments, when the first and second electrodes 141a and 142a are stacked in the first direction DR1, the parasitic capacitors C_{PAR1} and C_{PAR2} may be formed between the second well 121 and the first electrode 141a, which is a lower electrode among the first and second electrodes 141a and 142a.

Referring to FIG. 6B, first and second electrodes 141b and 142b may be spaced apart from each other in a direction (e.g., the second direction DR2) parallel to the upper surface of the semiconductor substrate 101.

For example, the first and second electrodes 141b and 142b may be disposed and/or formed in the same conductive layer within an insulating layer (not illustrated). For example, in the same conductive layer, the first electrode 141b may extend in the third direction DR3, and the second electrode 142b may extend in the third direction DR3 while being spaced apart from the first electrode 141b in the second direction DR2. For example, the first and second electrodes 141b and 142b and the insulating layer may be disposed and/or formed on the semiconductor substrate 101.

In some example embodiments, when the first and second electrodes 141b and 142b are spaced apart in the second direction DR2 in the same conductive layer, the parasitic capacitors C_{PAR1} and C_{PAR2} may be formed between the second well 121 and both the first and second electrodes 141b and 142b.

Referring to FIG. 6C, first and second electrodes 141c and 142c may be spaced apart from each other in directions (e.g., in the second and third directions DR2 and DR3) parallel to the upper surface of the semiconductor substrate 101. The descriptions repeated with or overlapping with descriptions of FIG. 6B will be omitted in the interest of brevity.

For example, the first and second electrodes 141c and 142c may be disposed and/or formed in the same conductive layer within an insulating layer (not illustrated). The first electrode 141c may include a first main electrode 145 that extends in the third direction DR3, and first sub-electrodes 146 that extend from the first main electrode 145 in the second direction DR2 and are arranged along the third direction DR3. The second electrode 142c may include a second main electrode 147 that extends in the third direction DR3, and second sub-electrodes 148 that extend from the second main electrode 147 in the second direction DR2 and are arranged along the third direction DR3. The first sub-electrodes 146 and the second sub-electrodes 148 may be arranged alternately along the third direction DR3, and thus the capacitance may be improved.

However, example embodiments are not limited thereto, and the configuration and arrangement of the first and second electrodes 141 and 142 for forming the capacitor element C_{UNIT} may be variously implemented according to example embodiments.

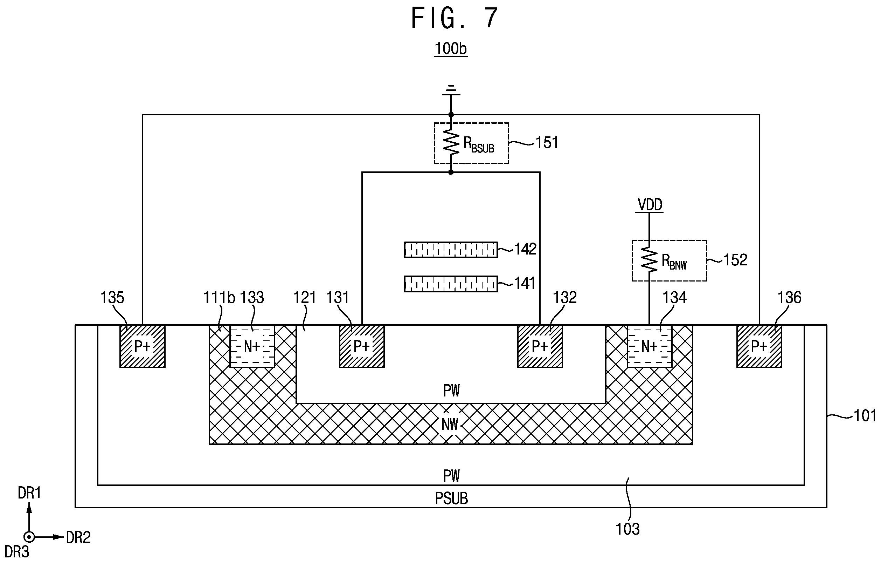

FIG. 7 is a diagram illustrating an example of a capacitor structure of FIG. 1. The descriptions repeated with or overlapping with descriptions of FIG. 2 will be omitted in the interest of brevity.

Referring to FIG. 7, a capacitor structure 100b includes a semiconductor substrate 101, an outer well 103, a first well 111b, a second well 121, a first electrode 141, a second electrode 142, a first choke impedance element 151 and a second choke impedance element 152. The capacitor structure 100b may further include a first impurity region 131, a second impurity region 132, a third impurity region 133, a fourth impurity region 134, a fifth impurity region 135 and a sixth impurity region 136.

The capacitor structure 100b may be substantially the same as the capacitor structure 100a of FIG. 2, except that a configuration of the first well 111b is changed.

The first well 111b may be formed integrally to surround the second well 121. In other words, unlike the first well 111, 112 and 113 in FIG. 2, which are divided into the first well region 111, the second well region 112 and the third well region 113, the first well 111b may be formed integrally.

The capacitor structure according to example embodiments may be implemented with the triple well structure, may include the first choke impedance element 151 connected between the second well 121 (e.g., the first and second impurity regions 131 and 132) and the ground voltage, and may include the second choke impedance element 152 connected between the first well 111, 112, 113 and 111b (e.g., the fourth impurity region 134) and the power supply voltage VDD. Accordingly, the parasitic capacitance may be reduced, and operating performance and characteristics may be improved.

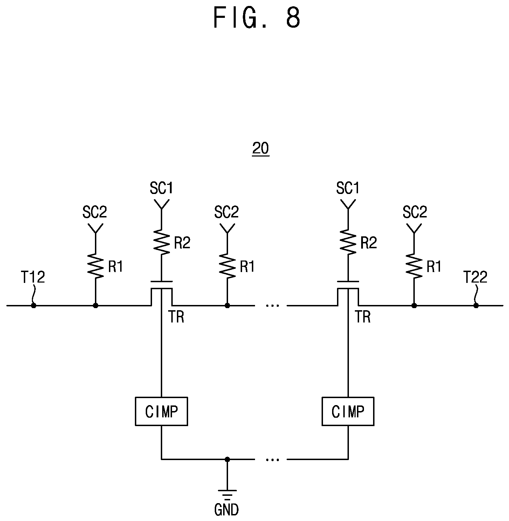

FIG. 8 is a diagram illustrating a switch structure according to example embodiments.

Referring to FIG. 8, a switch structure 20 controls an electrical connection between a first terminal T12 and a second terminal T22, and includes a plurality of transistors TR, a plurality of first resistors R1, a plurality of second resistors R2 and a plurality of choke impedance elements CIMP.

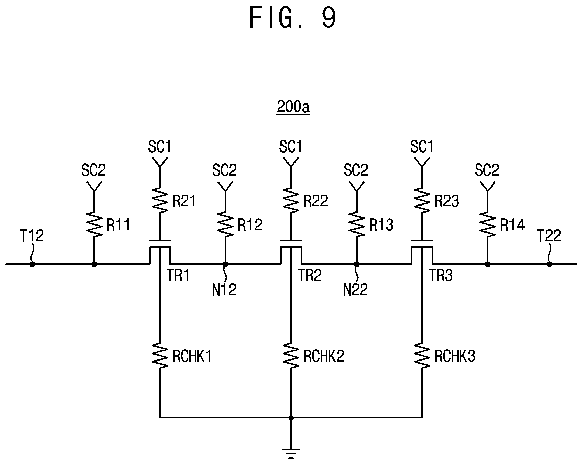

In some example embodiments, the switch structure 20 may be manufactured using a semiconductor process, and may further include various components disposed (or arranged) and/or formed in and/or on a semiconductor substrate. Example configurations of the switch structure 20 will be described with reference to FIGS. 9 through 12B.

The plurality of transistors TR are connected in series between the first terminal T12 and the second terminal T22. Each of the plurality of transistors TR has a gate electrode receiving a first switch control signal SC1. For example, each of the plurality of transistors TR may be an n-type metal oxide semiconductor (NMOS) transistor, but example embodiments are not limited thereto.

In some example embodiments, each of the plurality of transistors TR may be a thin gate-oxide transistor. For example, a thickness of an insulating layer disposed between the gate electrode of each of the plurality of transistors TR and the semiconductor substrate may be less than a reference thickness, but example embodiments are not limited thereto.

Each of the plurality of first resistors R1 is connected to the first terminal T12, the second terminal T22 or a node between two adjacent transistors among the plurality of transistors TR. A second switch control signal SC2 is applied to each of the plurality of first resistors R1. For example, one end of each of the plurality of first resistors R1 may be connected to the first terminal T12, the second terminal T22 or the node between two adjacent transistors among the plurality of transistors TR. For example, the second switch control signal SC2 may be applied to the other end of each of the plurality of first resistors R1.

As illustrated in FIG. 8, the plurality of first resistors R1 and the plurality of transistors TR may be alternately arranged between the first terminal T12 and the second terminal T22. Therefore, the number of the plurality of first resistors R1 may be greater than the number of the plurality of transistors TR by one.

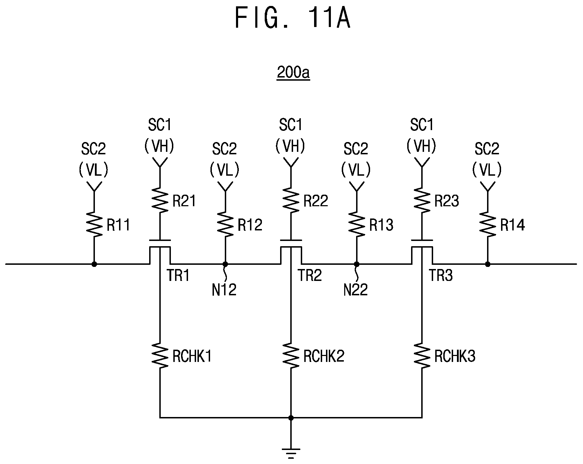

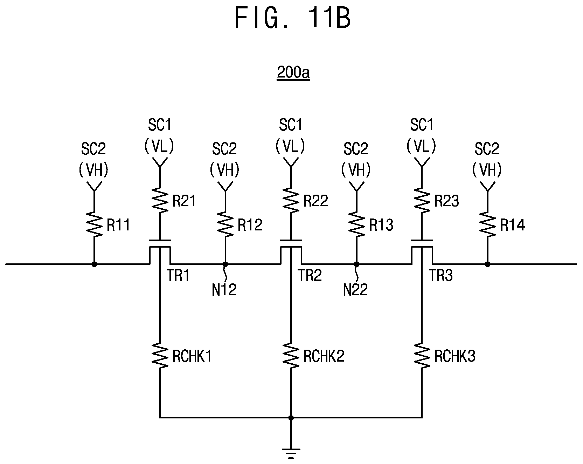

In some example embodiments, on and off of the switch structure 20 (e.g., electrical connection and disconnection between the first terminal T12 and the second terminal T22) may be controlled based on the first and second switch control signals SC1 and SC2, which will be described with reference to FIGS. 11A and 11B.

Each of the plurality of second resistors R2 is connected between the gate electrode of one of the plurality of transistors TR and the first switch control signal SC1. For example, one end of each of the plurality of second resistors R2 may be connected to the gate electrode of a respective one of the plurality of transistors TR. For example, the first switch control signal SC1 may be applied to the other end of a respective one of the plurality of second resistors R2. For example, one transistor TR and one second resistor R2 may be connected, and thus the number of the plurality of second resistors R2 may be equal to the number of the plurality of transistors TR.

Each of the plurality of choke impedance elements CIMP is connected between a body of one of the plurality of transistors TR and a ground voltage GND. For example, one end of each of the plurality of choke impedance elements CIMP may be connected to the body of a respective one of the plurality of transistors TR. For example, the other end of each of the plurality of choke impedance elements CIMP may be connected to the ground voltage GND. For example, one transistor TR and one choke impedance element CIMP may be connected, and thus the number of the plurality of choke impedance elements CIMP may be equal to the number of the plurality of transistors TR.

In some example embodiments, the plurality of transistors TR may have a body separation structure in which the bodies of the plurality of transistors TR are electrically isolated and/or separated, by the plurality of choke impedance elements CIMP.

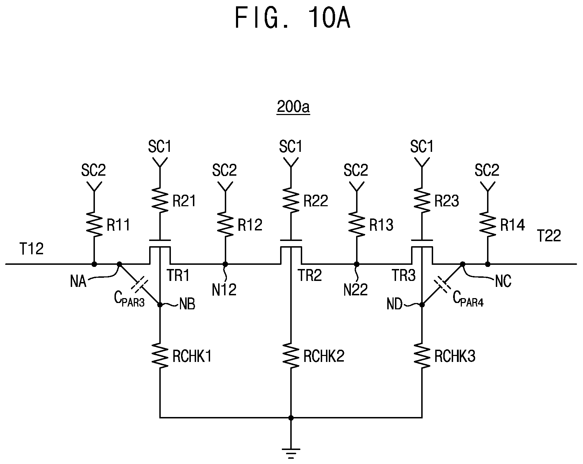

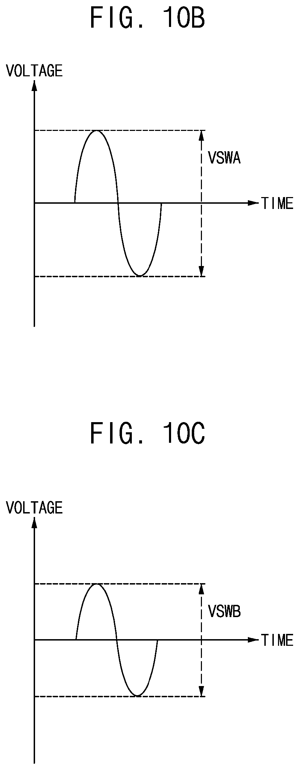

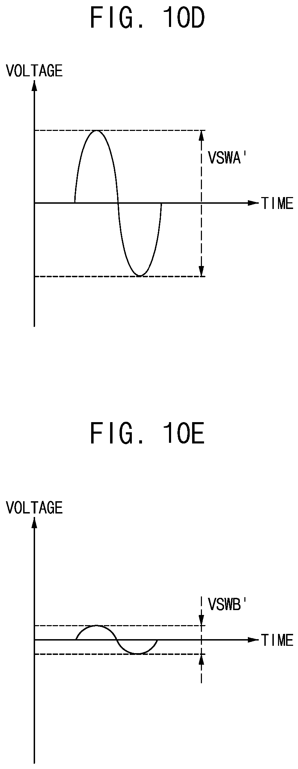

When the plurality of choke impedance elements CIMP are included in and connected to the switch structure 20, a parasitic capacitance of the switch structure 20 may be reduced, which will be described with reference to FIGS. 10A, 10B, 10C, 10D and 10E.

In some example embodiments, each of the plurality of choke impedance elements CIMP may be implemented to have a relatively high impedance.

In some example embodiments, the switch structure 20 may be included in various electronic devices that operate based on a relatively high operating frequency, and for example, may be included in an electronic device that performs a frequency tuning operation by adjusting a capacitance. For example, the switch structure 20 may be included in a capacitor array for performing and supporting the frequency tuning operation and for obtaining a relatively wide frequency tuning range.

FIG. 9 is a circuit diagram illustrating an example of a switch structure of FIG. 8.

Referring to FIG. 9, a switch structure 200a includes a plurality of transistors TR1, TR2 and TR3, a plurality of first resistors R11, R12, R13 and R14, a plurality of second resistors R21, R22 and R23 and a plurality of choke impedance elements.

The plurality of transistors TR1, TR2 and TR3 may include a first transistor TR1, a second transistor TR2 and a third transistor TR3. The first, second, and third transistors TR1, TR2 and TR3 may be connected in series between the first terminal T12 and the second terminal T22.

In some example embodiments, a stacked transistor structure may be implemented by a series connection of the plurality of transistors TR1, TR2 and TR3. For example, when three transistors TR1, TR2 and TR3 are connected in series, a three-stacked transistor structure may be formed, but example embodiments are not limited thereto.

The plurality of first resistors R11, R12, R13 and R14 may include a first-first resistor R11, a first-second resistor R12, a first-third resistor R13 and a first-fourth resistor R14. The first-first resistor R11 may be connected between the first terminal T12 and the second switch control signal SC2. The first-second resistor R12 may be connected between a node N12, which is disposed between the first and second transistors TR1 and TR2, and the second switch control signal SC2. The first-third resistor R13 may be connected between a node N22, which is disposed between the second and third transistors TR2 and TR3, and the second switch control signal SC2. The first-fourth resistor R14 may be connected between the second terminal T22 and the second switch control signal SC2.

The plurality of second resistors R21, R22 and R23 may include a second-first resistor R21, a second-second resistor R22 and a second-third resistor R23. The second-first resistor R21 may be connected between a gate electrode of the first transistor TR1 and the first switch control signal SC1. The second-second resistor R22 may be connected between a gate electrode of the second transistor TR2 and the first switch control signal SC1. The second-third resistor R23 may be connected between a gate electrode of the third transistor TR3 and the first switch control signal SC1.

In some example embodiments, the plurality of choke impedance elements may include a plurality of choke resistors RCHK1, RCHK2 and RCHK3, which include a first choke resistor RCHK1, a second choke resistor RCHK2 and a third choke resistor RCHK3. For example, the first choke resistor RCHK1 may be connected between a body of the first transistor TR1 and the ground voltage. The second choke resistor RCHK2 may be connected between the body of the second transistor TR2 and the ground voltage. The third choke resistor RCHK3 may be connected between the body of the third transistor TR3 and the ground voltage. For example, the plurality of choke impedance elements may have relatively high impedances using the plurality of choke resistors RCHK1, RCHK2 and RCHK3, but example embodiments are not limited thereto.

FIGS. 10A, 10B, 10C, 10D, 10E, 11A and 11B are diagrams for describing a switch structure of FIG. 9.

Referring to FIG. 10A, an example of parasitic components occurred by the components in the switch structure 200a is illustrated.

A parasitic capacitor C_{PAR3} may be formed between a node NA corresponding to the first terminal T12 and a node NB corresponding to the body of the first transistor TR1. Similarly, a parasitic capacitor C_{PAR4} may be formed between a node NC corresponding to the second terminal T22 and a node ND corresponding to the body of the third transistor TR3.

Referring to FIGS. 10B and 10C, an example of signals in the switch structure 200a according to example embodiments that includes the plurality of choke resistors RCHK1, RCHK2 and RCHK3 is illustrated. FIG. 10B illustrates a voltage level of a signal at the node NA, and FIG. 10C illustrates a voltage level of a signal at the node NB in response to the signal of FIG. 10B.

As illustrated in FIGS. 10B and 10C, when the switch structure 200a includes the plurality of choke resistors RCHK1, RCHK2 and RCHK3, a difference between a swing width VSWA of the signal at the node NA and a swing width VSWB of the signal at the node NB may be relatively small, and thus a parasitic capacitance by the parasitic capacitor C_{PAR3} may be reduced. Similarly, although not illustrated in detail, a signal at the node NC may be substantially the same as the signal at the node NA, a signal at the node ND may be substantially the same as the signal at the node NB, and thus a parasitic capacitance by the parasitic capacitor C_{PAR4} may be reduced.

Referring to FIGS. 10D and 10E, an example of signals in a conventional switch structure that does not include the plurality of choke resistors RCHK1, RCHK2 and RCHK3 is illustrated.

As illustrated in FIGS. 10D and 10E, when the conventional switch structure does not include the plurality of choke resistors RCHK1, RCHK2 and RCHK3, a difference between a swing width VSWA' of the signal at the node NA and a swing width VSWB' of the signal at the node NB may be relatively large, and thus a parasitic capacitance due to the parasitic capacitor C_{PAR3} may increase. Similarly, a parasitic capacitance due to the parasitic capacitor C_{PAR4} may also increase.

As described above, it can be seen that the parasitic capacitance of the switch structure 200a according to example embodiments that includes the plurality of choke resistors RCHK1, RCHK2 and RCHK3 is reduced, as compared with the conventional switch structure.

Referring to FIG. 11A, an example where the switch structure 200a is turned on, e.g., an example where the first terminal T12 and the second terminal T22 are electrically connected to each other by the switch structure 200a is illustrated. For example, when the first switch control signal SC1 has a first voltage level VH, and when the second switch control signal SC2 has a second voltage level VL, the switch structure 200a may be turned on, and the first terminal T12 and the second terminal T22 may be electrically connected to each other. For example, the first voltage level VH may be higher than the second voltage level VL.

Referring to FIG. 11B, an example where the switch structure 200a is turned off, e.g., an example where the first terminal T12 and the second terminal T22 are electrically disconnected from each other by the switch structure 200a. For example, when the first switch control signal SC1 has the second voltage level VL, and when the second switch control signal SC2 has the first voltage level VH, the switch structure 200a may be turned off, and the first terminal T12 and the second terminal T22 may be electrically disconnected from each other.

As described above, the switch structure 200a according to example embodiments that is implemented with the stacked transistor structure, the turn-on of the switch structure 200a and the turn-off of the switch structure 200a may be controlled using the same voltage levels VH and VL, and the reliability issues may not occur even if the same voltage levels VH and VL are used.

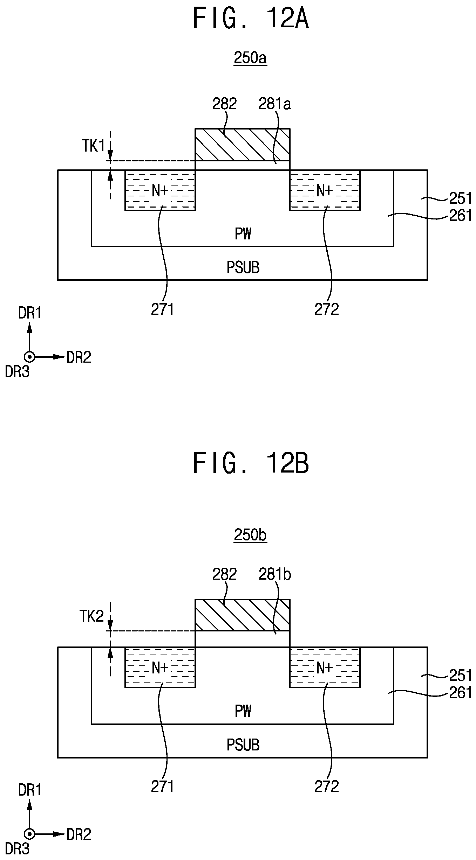

FIGS. 12A and 12B are diagrams illustrating examples of a transistor included in a switch structure of FIG. 9.

Referring to FIG. 12A, a transistor 250a may include a semiconductor substrate 251, a first well 261, a first impurity region 271, a second impurity region 272, an insulating layer 281a and a gate electrode 282.

The semiconductor substrate 251 may have a first conductivity type. The first well 261 may have the first conductivity type. For example, the first conductivity type may be a p-type conductivity. In this example, the semiconductor substrate 251 may correspond to a p-type substrate PSUB, and the first well 261 may correspond to a p-well PW.

The first and second impurity regions 271 and 272 may be disposed and/or formed in the first well 261, and may have a second conductivity type different from the first conductivity type. For example, in a cross-sectional view, the first and second impurity regions 271 and 272 may be spaced apart from each other along the second direction DR2 in the first well 261. For example, the second conductivity type may be an n-type conductivity. In this example, each of the first and second impurity regions 271 and 272 may be an n+ region. The first and second impurity regions 271 and 272 may correspond to source and drain regions of the transistor 250a.

The insulating layer 281a and the gate electrode 282 may be disposed and/or formed on the semiconductor substrate 251 (e.g., on the first well 261) between the first and second impurity regions 271 and 272. The insulating layer 281a may have a thickness TK1.

In some example embodiments, the thickness TK1 of the insulating layer 281a may be less than the reference thickness. In other words, the transistor 250a may be a thin gate-oxide transistor. When the stacked transistor structure including the plurality of transistors TR1, TR2 and TR3 is implemented, and when each transistor is implemented with the thin gate oxide transistor, the parasitic capacitance may be reduced and the reliability issues may be resolved.

Referring to FIG. 12B, a transistor 250b may include a semiconductor substrate 251, a first well 261, a first impurity region 271, a second impurity region 272, an insulating layer 281b and a gate electrode 282. The descriptions repeated with or overlapping with descriptions of FIG. 12A will be omitted in the interest of brevity.

The insulating layer 281b may have a thickness TK2. The transistor 250b may be substantially the same as the transistor 250a of FIG. 12A, except that the thickness TK2 of the insulating layer 281b is changed.

In some example embodiments, the thickness TK2 of the insulating layer 281b may be larger than the reference thickness. In other words, the transistor 250b may be a thick gate-oxide transistor. The plurality of transistors TR1, TR2 and TR3 included in the switch structure 200a according to example embodiments may not be limited to the thin gate-oxide transistors, and may be implemented with thick gate-oxide transistors.

Although the switch structure according to example embodiments is described based on a specific number of transistors, a specific number of first resistors, a specific number of second resistors and a specific number of choke resistors, example embodiments are not limited thereto.

The switch structure according to example embodiments may be implemented with the stacked transistor structure, and may include the plurality of choke impedance elements CIMP connected between the plurality of transistors TR and the ground voltage. Accordingly, the parasitic capacitance may be reduced, and the operating performance and characteristics may be improved.

FIGS. 13, 14 and 15 are block diagrams illustrating a capacitor array according to example embodiments.

Referring to FIG. 13, a capacitor array 30 includes a plurality of capacitors 31 and 33 and at least one switch 35. The capacitor array 30 may be referred to as a capacitor bank.

The plurality of capacitors 31 and 33 are connected between a first terminal T13 and a second terminal T23. For example, the plurality of capacitors 31 and 33 may include a first capacitor 31 to an Nth capacitor 33, where N is a positive integer greater than or equal to two.

The at least one switch 35 is disposed between two adjacent capacitors among the plurality of capacitors 31 and 33. For example, the at least one switch 35 may include a first switch 35.

As illustrated in FIG. 13, the plurality of capacitors 31 and 33 and the at least one switch 35 may be alternately arranged between the first terminal T13 and the second terminal T23. Therefore, the number of the capacitors 31 and 33 may be one more than the number of the switch 35. For example, when N=2, the first capacitor 31, the first switch 35 and a second capacitor may be arranged in the order between the first terminal T13 and the second terminal T23. For example, when N=3, the first capacitor 31, the first switch 35, the second capacitor, a second switch and a third capacitor may be arranged in the order between the first terminal T13 and the second terminal T23.

In some example embodiments, the capacitor array 30 may perform a frequency tuning operation by turning on and off the at least one switch 35. For example, the capacitor array 30 may be included in a transceiver that performs wireless communication, and the transceiver may perform the frequency tuning operation by controlling an operating frequency using a combination of an inductance of an inductor and a capacitance of a capacitor. In this example, the frequency tuning operation may be performed by controlling the capacitance of the capacitor array 30 by turning on and off the at least one switch 35.

In some example embodiments, each of the plurality of capacitors 31 and 33 may correspond to the capacitor structure according to example embodiments. For example, the plurality of capacitors 31 and 33 may have a structure in which the second wells 121 of the capacitors 31 and 33 are electrically isolated and/or separated from each other. For example, each of the plurality of capacitors 31 and 33 may include the first and second choke impedance elements CIMP1 and CIMP2. For example, as described with reference to FIGS. 1 through 7, each of the plurality of capacitors 31 and 33 may be implemented to have the triple well structure, may include the first choke impedance element 151 connected between the second well 121 (e.g., the first and second impurity regions 131 and 132) and the ground voltage, and may include the second choke impedance element 152 connected between the first well 111, 112, 113 and 111b (e.g., the fourth impurity region 134) and the power supply voltage VDD. The second wells 121 of the plurality of capacitors 31 and 33 may be electrically isolated and/or separated from each other by the triple well structure and the first choke impedance element CIMP1. Accordingly, parasitic capacitances of the plurality of capacitors 31 and 33 may be reduced, and the capacitor array 30 may have a relatively wide frequency tuning range.

In some example embodiments, the plurality of capacitors 31 and 33 may be formed in and/or on the same semiconductor substrate, and at least some of the plurality of capacitors 31 and 33 may share the outer well 103. In other words, at least some of the plurality of capacitors 31 and 33 may be formed in the same outer well.

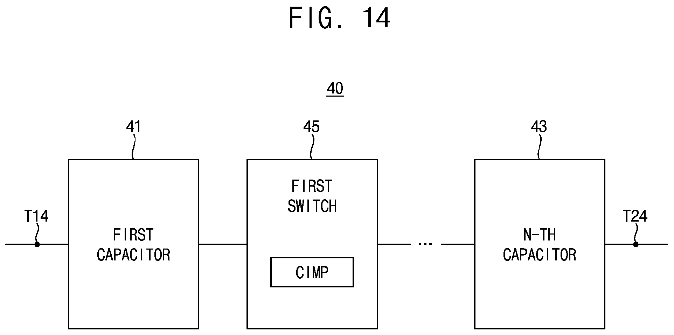

Referring to FIG. 14, a capacitor array 40 includes a plurality of capacitors 41 and 43 and at least one switch 45. The descriptions repeated with or overlapping with descriptions of FIG. 13 will be omitted in the interest of brevity.

The plurality of capacitors 41 and 43 are connected between a first terminal T14 and a second terminal T24. The at least one switch 45 is disposed between two adjacent capacitors among the plurality of capacitors 41 and 43.

In some example embodiments, the at least one switch 45 may correspond to the switch structure according to example embodiments. For example, the at least one switch 45 may include the plurality of choke impedance elements CIMP. For example, as described with reference to FIGS. 8 through 12B, the at least one switch 45 may be implemented with the stacked transistor structure, and may include the plurality of choke impedance elements CIMP connected between the plurality of transistors TR and the ground voltage. Accordingly, a parasitic capacitance of the at least one switch 45 may be reduced, and the capacitor array 40 may have a relatively wide frequency tuning range.

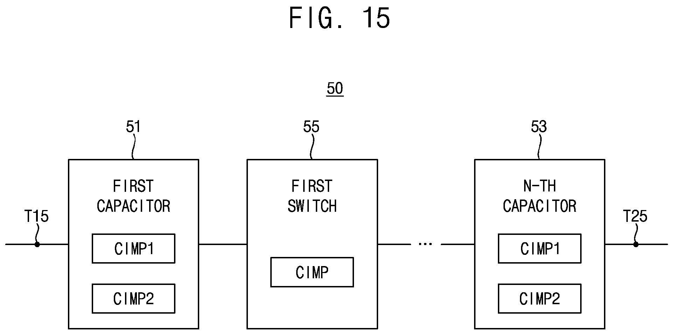

Referring to FIG. 15, a capacitor array 50 includes a plurality of capacitors 51 and 53 and at least one switch 55. The descriptions repeated with or overlapping with descriptions of FIGS. 13 and 14 will be omitted in the interest of brevity.

The plurality of capacitors 51 and 53 are connected between a first terminal T15 and a second terminal T25. The at least one switch 55 is disposed between two adjacent capacitors among the plurality of capacitors 51 and 53.

In some example embodiments, each of the plurality of capacitors 51 and 53 may correspond to the capacitor structure according to example embodiments, and the at least one switch 55 may correspond to the switch structure according to example embodiments. For example, the plurality of capacitors 51 and 53 may have a structure in which the second wells 121 of the capacitors 51 and 53 are electrically isolated and/or separated from each other, and each of the plurality of capacitors 51 and 53 may include the first and second choke impedance elements CIMP1 and CIMP2. For example, the at least one switch 55 may include the plurality of choke impedance elements CIMP. The second wells 121 of the plurality of capacitors 51 and 53 may be electrically isolated and/or separated from each other by the triple well structure and the first choke impedance element CIMP1. Accordingly, parasitic capacitances of the plurality of capacitors 51 and 53 may be reduced, a parasitic capacitance of the at least one switch 55 may be reduced, and the capacitor array 50 may have a relatively wide frequency tuning range.

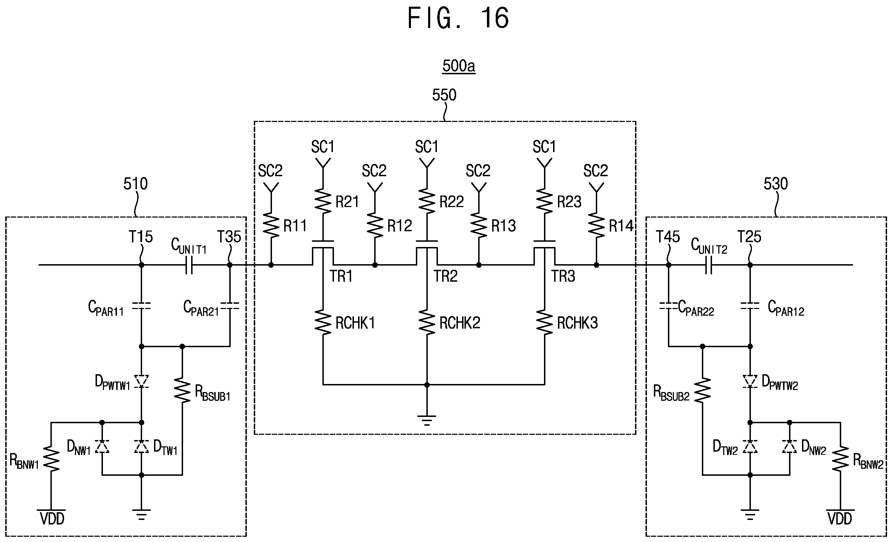

FIG. 16 is a circuit diagram illustrating an example of a capacitor array of FIG. 15.

Referring to FIG. 16, a capacitor array 500a may include a first capacitor 510, a first switch 550 and a second capacitor 530 that are connected between the first terminal T15 and the second terminal T25. FIG. 16 illustrates an example where N=2 in the capacitor array 50 of FIG. 15.

The first capacitor 510 may be connected between the first terminal T15 and a third terminal T35. The first capacitor 510 may correspond to the capacitor structure according to example embodiments, and may include components C_{UNIT1}, C_{PAR11}, C_{PAR21}, D_{PWTW1}, D_{TW1}, D_{NW1}, R_{BSUB1} and R_{BNW1}. The components C_{UNIT1}, C_{PAR11}, C_{PAR21}, D_{PWTW1}, D_{TW1}, D_{NW1}, R_{BSUB1} and R_{BNW1} included in the first capacitor 510 may be substantially the same as the components C_{UNIT}, C_{PAR1}, C_{PAR2}, D_{PWTW}, D_{TW}, D_{NW}, R_{BSUB} and R_{BNW} included in the equivalent circuit of FIG. 4, respectively.

The second capacitor 530 may be connected between a fourth terminal T45 and the second terminal T25. The second capacitor 530 may correspond to the capacitor structure according to example embodiments, and may include components C_{UNIT2}, C_{PAR12}, C_{PAR22}, D_{PWTW2}, D_{TW2}, D_{NW2}, R_{BSUB2} and R_{BNW2}. The components C_{UNIT2}, C_{PAR12}, C_{PAR22}, D_{PWTW2}, D_{TW2}, D_{NW2}, R_{BSUB2} and R_{BNW2} included in the second capacitor 530 may be substantially the same as the components C_{UNIT}, C_{PAR1}, C_{PAR2}, D_{PWTW}, D_{TW}, D_{NW}, R_{BSUB} and R_{BNW} included in the equivalent circuit of FIG. 4, respectively.

The first switch 550 may be connected between the third terminal T35 and the fourth terminal T45. The first switch 550 may correspond to the switch structure according to example embodiments, and may include components TR1, TR2, TR3, R11, R12, R13, R14, R21, R22, R23, RCHK1, RCHK2 and RCHK3. The components TR1, TR2, TR3, R11, R12, R13, R14, R21, R22, R23, RCHK1, RCHK2 and RCHK3 included in the first switch 550 may be substantially the same as the components TR1, TR2, TR3, R11, R12, R13, R14, R21, R22, R23, RCHK1, RCHK2 and RCHK3 included in the switch structure 200a of FIG. 9, respectively.

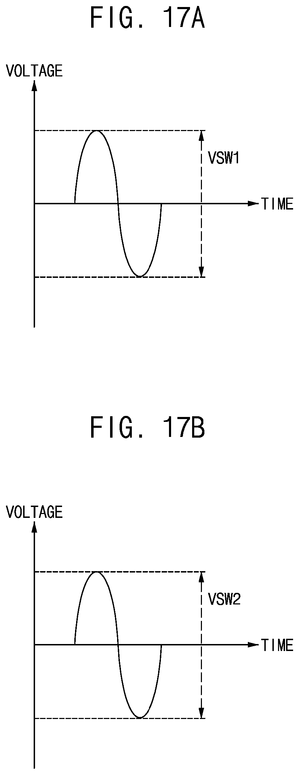

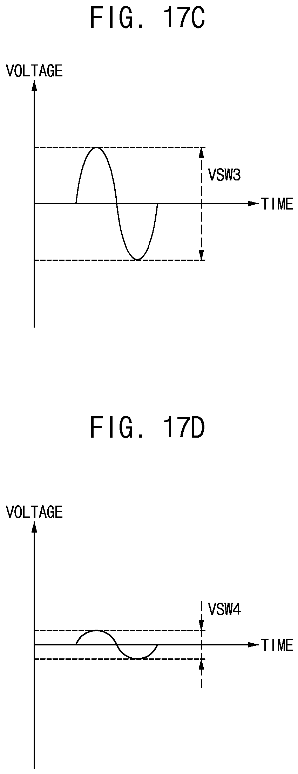

FIGS. 17A, 17B, 17C and 17D are diagrams for describing an operation of a capacitor array of FIG. 16.

Referring to FIG. 17A, signals at the first and second terminals T15 and T25 may have a swing width VSW1.

Referring to FIG. 17B, signals at the third and fourth terminals T35 and T45 may have a swing width VSW2. For example, the swing width (VSW2) may be substantially the same as the swing width VSW1.

Referring to FIG. 17C, signals near the second resistors R21 and R23 may have a swing width VSW3. For example, the swing width VSW3 may be smaller than the swing widths VSW1 and VSW2.

Referring to FIG. 17D, signals near the choke resistors RCHK1, RCHK2 and RCHK3 may have a swing width VSW4. For example, the swing width VSW4 may be smaller than the swing widths VSW1, VSW2 and VSW3.

FIGS. 18, 19 and 20 are block diagrams illustrating an electronic device according to example embodiments.

Referring to FIG. 18, an electronic device 60 includes at least one capacitor 61.

The at least one capacitor 61 may correspond to the capacitor structure according to example embodiments. For example, the at least one capacitor 61 may have a structure in which the second wells 121 are electrically isolated and/or separated from each other, and may include the first and second choke impedance elements CIMP1 and CIMP2. Accordingly, a parasitic capacitance of the at least one capacitor 61 may be reduced.

Referring to FIG. 19, an electronic device 70 includes at least one switch 71.

The at least one switch 71 may correspond to the switch structure according to example embodiments. For example, the at least one switch 71 may include the plurality of choke impedance elements CIMP. Accordingly, a parasitic capacitance of the at least one switch 71 may be reduced.

Although not illustrated in detail, an electronic device according to example embodiments may include both a capacitor corresponding to the capacitor structure according to example embodiments and a switch corresponding to the switch structure according to example embodiments.

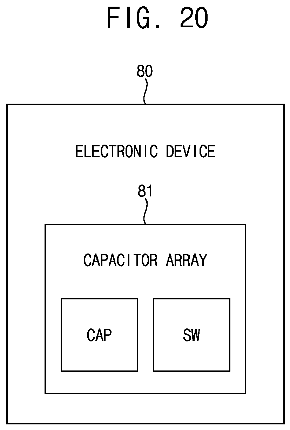

Referring to FIG. 20, an electronic device 80 includes a capacitor array 81.

The capacitor array 81 may include a plurality of capacitors CAP and at least one switch SW. The capacitor array 81 may be the capacitor array according to the example embodiments described with reference to FIGS. 13 through 17D. For example, each of the plurality of capacitors CAP may correspond to the capacitor structure according to example embodiments including the first and second choke impedance elements CIMP1 and CIMP2. For example, the at least one switch SW may correspond to the switch structure according to example embodiments including the plurality of choke impedance elements CIMP. For example, both the plurality of capacitors CAP and the at least one switch SW may correspond to the capacitor structure and the switch structure according to example embodiments.

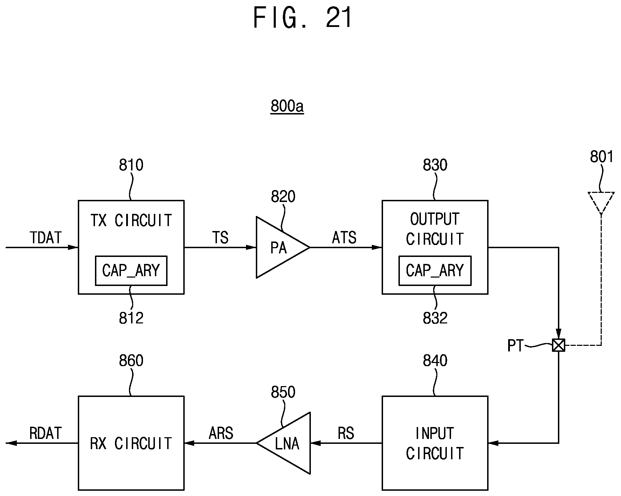

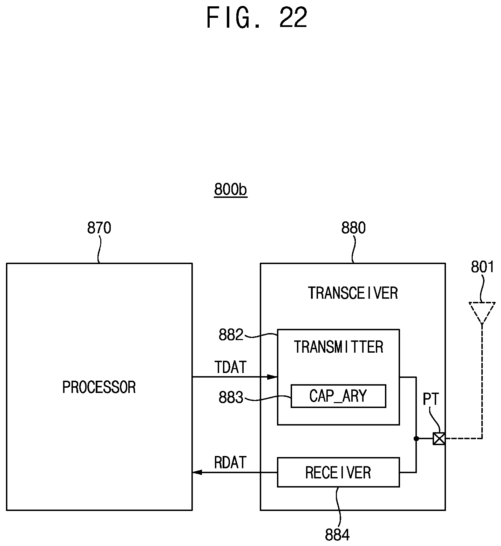

FIGS. 21 and 22 are block diagrams illustrating examples of an electronic device of FIG. 20.

Referring to FIG. 21, a transceiver 800a may include a transmission (TX) circuit 810, a first amplifier 820, an output circuit 830, an input circuit 840, a second amplifier 850, a reception (RX) circuit 860 and an input/output (I/O) port PT. The transceiver 800a may be connected to an antenna 801 that is located outside the transceiver 800a. FIG. 21 illustrates an example where the electronic device is implemented in the form of the transceiver 800a.

The transmission circuit 810 may generate a first signal (or transmission signal) TS based on the first data TDAT. For example, the first data TDAT may be provided from a processor that is located outside the transceiver 800a. For example, although not illustrated in detail, the transmission circuit 810 may include a mixer, an analog filter, etc.

The first amplifier 820 may amplify the first signal TS, and may generate an amplified first signal ATS. For example, the first amplifier 820 may be or include a power amplifier (PA).

The output circuit 830 may output the amplified first signal ATS to an external device (e.g., another electronic device and/or another transceiver). For example, although not illustrated in detail, the output circuit 830 may include an impedance matching circuit, a filter, etc.

The transmission circuit 810, the first amplifier 820 and the output circuit 830 may form a transmitter and/or a transmission path.

The input circuit 840 may receive a second signal (or reception signal) RS from the external device. For example, although not illustrated in detail, the input circuit 840 may include an impedance matching circuit, a filter, etc.

The second amplifier 850 may amplify the second signal RS, and may generate an amplified second signal ARS. For example, the second amplifier 850 may be or include a low noise amplifier (LNA).

The reception circuit 860 may generate second data RDAT based on the amplified second signal ARS. For example, the second data RDAT may be output externally from the transceiver 800a, and may be transmitted to the processor. For example, although not illustrated in detail, the reception circuit 860 may include a mixer, an analog filter, etc.

The input circuit 840, the second amplifier 850 and the reception circuit 860 may form a receiver and/or a reception path.

The I/O port PT may be connected to the transmitter or transmission path and the receiver (or reception path), and may be shared by the transmitter and the receiver. The I/O port PT may be connected to the antenna 801, and may output the amplified first signal ATS or may receive the second signal RS through the antenna 801. For example, the amplified first signal ATS may be output to the outside of the transceiver 800a, and may be transmitted to another electronic device and/or another transceiver. For example, the second signal RS may be provided from another electronic device and/or another transceiver.

In some example embodiments, the transceiver 800a may operate in a transmission mode and a reception mode. For example, in the transmission mode, the transmitter may be enabled or activated, may receive the first data TDAT, and may generate and output the first signal, and at this time, the receiver may be disabled or deactivated. For example, in the reception mode, the receiver may be enabled or activated, may receive the second signal, and may generate and output the second data RDAT, and at this time, the transmitter may be disabled or deactivated.

In some example embodiments, the transceiver 800a may operate in an operation mode in which the transmitter and the receiver are enabled or activated together. For example, to support high output power and wide bandwidth, and to support a radio detecting and ranging (RADAR) function, the transceiver 800a may be implemented with the I/O port PT that is shared by the transmitter and the receiver. For example, the transceiver 800a for the RADAR function may operate with the transmitter and the receiver that are enabled substantially simultaneously or concurrently.

In some example embodiments, the transmission circuit 810 may include a capacitor array (CAP_ARY) 812, and the output circuit 830 may include a capacitor array 832. Each of the capacitor arrays 812 and 832 may be the capacitor array according to example embodiments, and may perform the frequency tuning operation by adjusting the capacitance. In addition, the parasitic capacitance of the internal elements may be reduced, and a relatively wide frequency tuning range may be achieved.

Although not illustrated in FIG. 21, only one of the transmission circuit 810 and the output circuit 830 may include the capacitor array according to example embodiments. In addition, at least one of the input circuit 840 and the reception circuit 860 may also include the capacitor array according to example embodiments.

Referring to FIG. 22, a semiconductor chip 800b may include a processor 870 and a transceiver 880. FIG. 22 illustrates an example where the electronic device is implemented in the form of the semiconductor chip 800b.

In some example embodiments, the processor 870 and the transceiver 880 may be implemented as a single integrated circuit (IC) (or chip or module).

The processor 870 may generate first data TDAT that is to be transmitted to an external device. For example, the processor 870 may perform various signal processing such as modulation/demodulation, encoding/decoding, channel estimation, etc. The processor 870 may be referred to as a communication processor, a modem, etc. In addition, the processor 870 may exchange baseband signals with the transceiver 880, and may be referred to as a baseband processor.

The transceiver 880 may generate a first signal that is to be transmitted to the external device based on the first data TDAT. The transceiver 880 may be the transceiver according to example embodiments described with reference to FIG. 21. For example, the transceiver 880 may include a transmitter 882, a receiver 884 and an I/O port PT, and the transmitter 882 may include a capacitor array 883. The capacitor array 883 may be the capacitor array according to example embodiments.

In addition, the transceiver 880 may receive a second signal from the external device, and may generate second data RDAT based on the second signal. The processor 870 may receive the second data RDAT, and may perform data processing on the second data RDAT.

The capacitor structure, the switch structure and/or the capacitor array according to example embodiments may be applied or employed to the transceiver that operates in multiple frequency bands, supports wide bandwidth, and requires high output power. For example, when the capacitor structure according to example embodiments is applied or employed, the parasitic capacitance may be reduced using the choke impedance elements CIMP1 and CIMP2, thereby reducing the insertion loss and supporting the wide frequency range. For example, when the switch structure according to example embodiments is applied or employed, the parasitic capacitance may be reduced using the choke impedance elements CIMP, thereby resolving the reliability issues.

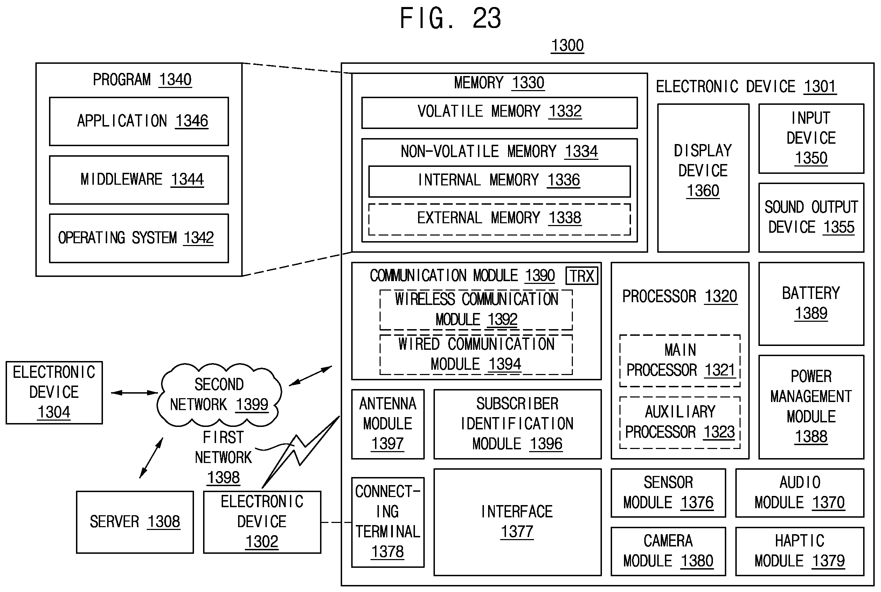

FIG. 23 is a block diagram illustrating an electronic device in a network environment according to example embodiments.

Referring to FIG. 23, an electronic device 1301 in a network environment 1300 may communicate with an electronic device 1302 via a first network 1398 (e.g., a short-range wireless communication network), or an electronic device 1304 or a server 1308 via a second network 1399 (e.g., a long-range wireless communication network). For example, the electronic device 1301 may communicate with the electronic device 1304 via the server 1308. For example, the electronic device 1301 may include a processor 1320, a memory 1330, an input device 1350, a sound output device 1355, a display device 1360, an audio module 1370, a sensor module 1376, an interface 1377, a haptic module 1379, a camera module 1380, a power management module 1388, a battery 1389, a communication module 1390, a subscriber identification module (SIM) 1396, and/or an antenna module 1397. **In** some example embodiments, at least one (e.g., the display device 1360 or the camera module 1380) of the components may be omitted from the electronic device 1301, or one or more other components may be added in the electronic device 1301. **In** some example embodiments, some of the components may be implemented as single integrated circuitry. For example, the sensor module 1376 (e.g., a fingerprint sensor, an iris sensor, or an illuminance sensor) may be implemented as embedded in the display device 1360 (e.g., a display).

The processor 1320 may execute, for example, software (e.g., a program 1340) to control at least one other component (e.g., a hardware or software component) of the electronic device 1301 coupled with the processor 1320, and may perform various data processing or computation. For example, as at least part of the data processing or computation, the processor 1320 may load a command or data received from another component (e.g., the sensor module 1376 or the communication module 1390) in a volatile memory 1332, process the command or the data stored in the volatile memory 1332, and store resulting data in a nonvolatile memory 1334. **In** some example embodiments, the processor 1320 may include a main processor 1321 (e.g., a central processing unit (CPU) or an application processor (AP)), and an auxiliary processor 1323 (e.g., a graphics processing unit (GPU), an image signal processor (ISP), a sensor hub processor, or a communication processor (CP)) that is operable independently from, or in conjunction with, the main processor 1321. Additionally or alternatively, the auxiliary processor 1323 may be adapted to consume less power than the main processor 1321, or to be specific to a specified function. The auxiliary processor 1323 may be implemented as separate from, or as part of the main processor 1321.

The auxiliary processor 1323 may control at least some of functions or states related to at least one component (e.g., the display device 1360, the sensor module 1376, or the communication module 1390) among the components of the electronic device 1301, instead of the main processor 1321 while the main processor 1321 is in an inactive (e.g., sleep) state, or together with the main processor 1321 while the main processor 1321 is in an active state (e.g., executing an application). **In** some example embodiments, the auxiliary processor 1323 (e.g., an image signal processor or a communication processor) may be implemented as part of another component (e.g., the camera module 1380 or the communication module 1390) functionally related to the auxiliary processor 1323.

The memory 1330 may store various data used by at least one component (e.g., the processor 1320 or the sensor module 1376) of the electronic device 1301. The various data may include, for example, software (e.g., the program 1340) and input data or output data for a command related thereto. The memory 1330 may include the volatile memory 1332 and/or the nonvolatile memory 1334. The memory 1330 may include an internal memory 1336 and an external memory 1338.

The program 1340 may be stored in the memory 1330 as software, and may include, for example, an operating system (OS) 1342, middleware 1344, and/or an application 1346.

The input device 1350 may receive a command or data to be used by another component (e.g., the processor 1320) of the electronic device 1301, from the outside (e.g., a user) of the electronic device 1301. The input device 1350 may include, for example, a microphone, a mouse, a keyboard, or a digital pen (e.g., a stylus pen).

The sound output device 1355 may output sound signals to the outside of the electronic device 1301. The sound output device 1355 may include, for example, a speaker or a receiver. The speaker may be used for general purposes, such as playing multimedia or playing record, and the receiver may be used for incoming calls. In some example embodiments, the receiver may be implemented as separate from, or as part of the speaker.

The display device 1360 may visually provide information to the outside (e.g., a user) of the electronic device 1301. The display device 1360 may include, for example, a display, a hologram device, or a projector and control circuitry to control a corresponding one of the display, hologram device, and projector. In some example embodiments, the display device 1360 may include touch circuitry adapted to detect a touch, or sensor circuitry (e.g., a pressure sensor) adapted to measure the intensity of force incurred by the touch.

The audio module 1370 may convert a sound into an electrical signal and vice versa. In some example embodiments, the audio module 1370 may obtain the sound via the input device 1350, or output the sound via the sound output device 1355 or a headphone of an external electronic device (e.g., an electronic device 1302) directly (e.g., wired) or wirelessly coupled with the electronic device 1301.

The sensor module 1376 may detect an operational state (e.g., power or temperature) of the electronic device 1301 or an environmental state (e.g., a state of a user) external to the electronic device 1301, and then generate an electrical signal or data value corresponding to the detected state. In some example embodiments, the sensor module 1376 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor, but example embodiments are not limited thereto.

The interface 1377 may support one or more specified protocols to be used for the electronic device 1301 to be coupled with the external electronic device (e.g., the electronic device 1302) directly (e.g., wired) or wirelessly. In some example embodiments, the interface 1377 may include, for example, a high definition multimedia interface (HDMI), a universal serial bus (USB) interface, a secure digital (SD) card interface, and/or an audio interface, but example embodiments are not limited thereto.

A connecting terminal 1378 may include a connector via which the electronic device 1301 may be physically connected with the external electronic device (e.g., the electronic device 1302). In some example embodiments, the connecting terminal 1378 may include, for example, a HDMI connector, a USB connector, a SD card connector, and/or an audio connector (e.g., a headphone connector), but example embodiments are not limited thereto.

The haptic module 1379 may convert an electrical signal into a mechanical stimulus (e.g., a vibration or a movement) or electrical stimulus which may be recognized by a user via his tactile sensation or kinesthetic sensation. In some example embodiments, the haptic module 1379 may include, for example, a motor, a piezoelectric element, and/or an electric stimulator.

The camera module 1380 may capture a still image or moving images. In some example embodiments, the camera module 1380 may include one or more lenses, image sensors, image signal processors, and/or flashes.

The power management module 1388 may manage power supplied to the electronic device 1301. In some example embodiments, the power management module 1388 may be implemented as at least part of, for example, a power management integrated circuit (PMIC).

The battery 1389 may supply power to at least one component of the electronic device 1301. In some example embodiments, the battery 1389 may include, for example, a primary cell which is not rechargeable, a secondary cell which is rechargeable, or a fuel cell.

The communication module 1390 may support establishing a direct (e.g., wired) communication channel or a wireless communication channel between the electronic device 1301 and the external electronic device (e.g., the electronic device 1302, the electronic device 1304, or the server 1308) and performing communication via the established communication channel. The communication module 1390 may include one or more communication processors that are operable independently from the processor 1320 (e.g., the application processor (AP)) and supports a direct (e.g., wired) communication or a wireless communication. In some example embodiments, the communication module 1390 may include a wireless communication module 1392 (e.g., a cellular communication module, a short-range wireless communication module, or a global navigation satellite system (GNSS) communication module) and/or a wired communication module 1394 (e.g., a local area network (LAN) communication module or a power line communication (PLC) module). A corresponding one of these communication modules may communicate with the external electronic device via the first network 1398 (e.g., a short-range communication network, such as Bluetooth^{™}, wireless-fidelity (Wi-Fi) direct, or infrared data association (IrDA)) or the second network 1399 (e.g., a long-range communication network, such as a cellular network, the Internet, or a computer network (e.g., LAN or wide area network (WAN)). These various types of communication modules may be implemented as a single component (e.g., a single chip), or may be implemented as multi-components (e.g., multi-chips) separate from each other. The wireless communication module 1392 may identify and authenticate the electronic device 1301 in a communication network, such as the first network 1398 or the second network 1399, using subscriber information (e.g., international mobile subscriber identity (IMSI)) stored in the subscriber identification module 1396.

The antenna module 1397 may transmit or receive a signal or power to or from the outside (e.g., the external electronic device) of the electronic device 1301. In some example embodiments, the antenna module 1397 may include an antenna including a radiating element composed of a conductive material or a conductive pattern formed in or on a substrate (e.g., PCB). In some example embodiments, the antenna module 1397 may include a plurality of antennas. In some example embodiments, at least one antenna appropriate for a communication scheme used in the communication network, such as the first network 1398 or the second network 1399, may be selected, for example, by the communication module 1390 (e.g., the wireless communication module 1392) from the plurality of antennas. The signal or the power may then be transmitted or received between the communication module 1390 and the external electronic device via the selected at least one antenna. In some example embodiments, another component (e.g., a radio frequency integrated circuit (RFIC)) other than the radiating element may be additionally formed as part of the antenna module 1397.

In some example embodiments, the communication module 1390 may include a transceiver TRX according to example embodiments. A part or all of the processor 1320 may be the processor included in the semiconductor chip according to example embodiments. In some example embodiments, a part or all of the transceiver TRX and the processor 1320 may be implemented as separate chips or as a single chip. The antenna module 1397 may include an antenna connected to the transceiver TRX. Similarly, other electronic devices 1302 and 1304 may also include transceivers, processors, antennas, etc., according to example embodiments. For example, each electronic device may be a user equipment (UE) or a base station.

The example embodiments may be applied to various communication devices and systems, and electronic devices and systems that include the communication devices and systems. For example, the example embodiments may be applied to systems such as a personal computer (PC), a server computer, a data center, a workstation, a mobile phone, a smart phone, a tablet computer, a laptop computer, a personal digital assistant (PDA), a portable multimedia player (PMP), a digital camera, a portable game console, a music player, a camcorder, a video player, a navigation device, a wearable device, an internet of things (IoT) device, an internet of everything (IoE) device, an e-book reader, a virtual reality (VR) device, an augmented reality (AR) device, a robotic device, a drone, an automotive, etc.

The foregoing is illustrative of example embodiments and is not to be construed as limiting thereof. Although some example embodiments have been described, those skilled in the art will readily appreciate that many modifications are possible in the example embodiments without materially departing from the novel teachings and advantages of the example embodiments. Accordingly, all such modifications are intended to be included within the scope of the example embodiments as defined in the claims. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

Embodiments are set out in the following clauses:
Clause 1. A switch structure configured to control an electrical connection between a first terminal and a second terminal, the switch structure comprising:
   a plurality of transistors connected in series between the first terminal and the second terminal, each of the plurality of transistors comprising a gate electrode receiving a first switch control signal;
   a plurality of first resistors, each of the plurality of first resistors being connected to the first terminal, the second terminal or a node between two adjacent transistors among the plurality of transistors, a second switch control signal being applied to each of the plurality of first resistors;
   a plurality of second resistors, each of the plurality of second resistors being connected between the gate electrode of a transistor of the plurality of transistors and the first switch control signal; and
   a plurality of choke impedance elements, each of the plurality of choke impedance elements being connected between a body of a transistor of the plurality of transistors and a ground voltage.
Clause 2. The switch structure of clause 1, wherein bodies of the plurality of transistors are electrically isolated or separated by the plurality of choke impedance elements.
Clause 3. The switch structure of clause 1 or clause 2, wherein the plurality of choke impedance elements are configured to reduce a parasitic capacitance of the switch structure.
Clause 4. The switch structure of clause 3, wherein each of the plurality of choke impedance elements comprises a choke resistor.
Clause 5. The switch structure of any of clauses 1-4, wherein the plurality of transistors comprises a first transistor, a second transistor and a third transistor that are connected in series between the first terminal and the second terminal.
Clause 6. The switch structure of clause 5, wherein the plurality of first resistors comprises:
   a first-first resistor connected between the first terminal and the second switch control signal;
   a first-second resistor connected between a first node and the second switch control signal, the first node being between the first transistor and the second transistor;
   a first-third resistor connected between a second node and the second switch control signal, the second node being between the second transistor and the third transistor; and
   a first-fourth resistor connected between the second terminal and the second switch control signal.
Clause 7. The switch structure of clause 5 or clause 6, wherein the plurality of second resistors comprises:
   a second-first resistor connected between a gate electrode of the first transistor and the first switch control signal;
   a second-second resistor connected between a gate electrode of the second transistor and the first switch control signal; and
   a second-third resistor connected between a gate electrode of the third transistor and the first switch control signal.
Clause 8. The switch structure of any of clauses 5-7, wherein the plurality of choke impedance elements comprises:
   a first choke resistor connected between a body of the first transistor and the ground voltage;
   a second choke resistor connected between a body of the second transistor and the ground voltage; and
   a third choke resistor connected between a body of the third transistor and the ground voltage.
Clause 9. The switch structure of any of clauses 1-8, wherein a thickness of an insulating layer between the gate electrode of each of the plurality of transistors and a semiconductor substrate is less than a reference thickness.
Clause 10. The switch structure of any of clauses 1-9, wherein each of the plurality of transistors is an n-type metal oxide semiconductor transistor.
Clause 11. An electronic device comprising:
   at least one capacitor,
   wherein the at least one capacitor comprises:
      a semiconductor substrate comprising an outer well having a first conductivity type;
      a first well in the outer well and having a second conductivity type;
      a second well in the first well and having the first conductivity type;
      a first electrode and a second electrode, at least portions of the first electrode and the second electrode contacting the second well;
      a first choke impedance element connected between the second well and a ground voltage; and
      a second choke impedance element connected between the first well and a power supply voltage.
Clause 12. The electronic device of clause 11, wherein the electronic device comprises a transceiver configured to perform wireless communication.
Clause 13. The electronic device of clause 12, wherein the transceiver comprises:
   a transmission circuit configured to generate a first signal based on first data;
   a first amplifier configured to amplify the first signal;
   an output circuit configured to output the amplified first signal to an external device;
   an input circuit configured to receive a second signal from the external device;
   a second amplifier configured to amplify the second signal;
   a reception circuit configured to generate second data based on the amplified second signal; and
   an input/output (I/O) port commonly connected to the output circuit and the input circuit.
Clause 14. The electronic device of clause 13, further comprising at least one switch,
   wherein the at least one capacitor and the at least one switch form a capacitor array, and
   wherein the capacitor array is included in one of the transmission circuit and the output circuit.

## Claims

1. A capacitor structure (10) comprising:
a semiconductor substrate (101) comprising an outer well (103) having a first conductivity type;
a first well (111, 112, 113) in the outer well (103) and having a second conductivity type;
a second well (121) in the first well (111, 112, 113) and having the first conductivity type;
a first electrode (141) and a second electrode (142), at least portions of the first electrode (141) and the second electrode (142) being on the second well (121);
a first choke impedance element (151) connected between the second well (121) and a ground voltage (GND); and
a second choke impedance element (152) connected between the first well (121) and a power supply voltage (VDD).

2. The capacitor structure (10) of claim 1, further comprising:
a first impurity region (131) and a second impurity region (132) in the second well (121), each of the first impurity region (131) and the second impurity region (132) having the first conductivity type;
a third impurity region (133) and a fourth impurity region (134) in the first well (111, 112, 113), each of the third impurity region (133) and the fourth impurity region (134) having the second conductivity type; and
a fifth impurity region (135) and a sixth impurity region (136) in the outer well (103), each of the fifth impurity region and the sixth impurity region having the first conductivity type.

3. The capacitor structure (10) of claim 2, wherein the first impurity region (131) and the second impurity region (132) in the second well (121) are connected to the ground voltage (GND) through the first choke impedance element (151), and
wherein the fifth impurity region (135) and the sixth impurity region (136) in the outer well (103) are directly connected to the ground voltage (GND).

4. The capacitor structure (10) of any preceding claim, wherein the first choke impedance element (151) and the second choke impedance element (152) are configured to reduce a parasitic capacitance of the capacitor structure (10).

5. The capacitor structure (10) of claim 4, wherein each of the first choke impedance element (151) and the second choke impedance element (152) comprises a choke resistor.

6. The capacitor structure (10) of any preceding claim, wherein the second electrode (142) is stacked on the first electrode (141) in a direction perpendicular to an upper surface of the semiconductor substrate (101).

7. The capacitor structure (10) of any preceding claim, wherein the first electrode (141) and the second electrode (142) are spaced apart from each other in a direction parallel to an upper surface of the semiconductor substrate (101).

8. The capacitor structure (10) of any of claims 2-7, wherein the first impurity region (131) and the second impurity region (132) are spaced apart from each other in the second well (121),
wherein the third impurity region (133) and the fourth impurity region (134) are spaced apart from each other in the first well (111, 112, 113), and
wherein the fifth impurity region (135) and the sixth impurity region (136) are spaced apart from each other in the outer well (103).

9. The capacitor structure of any of claims 2-8, wherein an impurity concentration of the first impurity region (131) and an impurity concentration of the second impurity region (132) are higher than an impurity concentration of the second well (121),
wherein an impurity concentration of the third impurity region (133) and an impurity concentration of the fourth impurity region (134) are higher than an impurity concentration of the first well (111, 112, 113), and
wherein an impurity concentration of the fifth impurity region (135) and an impurity concentration of the sixth impurity region (136) are higher than an impurity concentration of the outer well (103).

10. The capacitor structure (10) of any preceding claim, wherein the first conductivity type is a p-type conductivity, and the second conductivity type is an n-type conductivity.

11. A capacitor array (30) comprising:
a plurality of capacitors (31, 33) connected between a first terminal (T15) and a second terminal (T25); and
at least one switch (35) between two adjacent capacitors (31, 33) among the plurality of capacitors (31, 33),
wherein each capacitor (31, 33) of the plurality of capacitors (31, 33) comprises:
an outer well (103) having a first conductivity type;
a first well (111, 112, 113) in the outer well (103) and having a second conductivity type;
a second well (121) in the first well (111, 112, 113) and having the first conductivity type; and
a first electrode (141) and a second electrode (142), at least portions of the first electrode (141) and the second electrode (142) on the second well (121), and
wherein the second well (121) of each capacitor (31, 33) of the plurality of capacitors (31, 33) is electrically isolated from other second wells (121) of other capacitors (31, 33) of the plurality of capacitors (31, 33).

12. The capacitor array (30) of claim 11, wherein each capacitor (31, 33) of the plurality of capacitors (31, 33) further comprises:
a first choke impedance element (151) connected between the second well (121) and a ground voltage (GND); and
a second choke impedance element (152) connected between the first well (111, 112, 113) and a power supply voltage (VDD).

13. The capacitor array (30) of claim 11 or claim 12, wherein the at least one switch (35) comprises:
a plurality of transistors (TR1, TR2, TR3) connected in series between a third terminal (T35) and a fourth terminal (T45), each of the plurality of transistors (TR1, TR2, TR3) comprising a gate electrode receiving a first switch control signal (SC1), the third terminal (T35) and the fourth terminal (T45) being between the two adjacent capacitors (C31, C33);
a plurality of first resistors (R11, R12, R13, R14), each of the plurality of first resistors (R11, R12, R13, R14) being connected to the third terminal (T35), the fourth terminal (T45) or a node between two adjacent transistors (TR1, TR2, TR3) among the plurality of transistors (TR1, TR2, TR3), a second switch control signal (SC2) being applied to each of the plurality of first resistors (R11, R12, R13, R14);
a plurality of second resistors (R21, R22, R23), each of the plurality of second resistors (R21, R22, R23) being connected between the gate electrode of one of the plurality of transistors (TR1, TR2, TR3) and the first switch control signal (SC1); and
a plurality of choke impedance elements (RCHK1, RCHK2, RCHK3), each of the plurality of choke impedance elements being connected between a body of a transistor (TR1, TR2, TR3) of the plurality of transistors (TR1, TR2, TR3) and a ground voltage (GND).

14. The capacitor array (30) of any of claims 11-13, wherein the capacitor array is configured to perform a frequency tuning operation by turning on and off the at least one switch (35).

15. An electronic device (60) comprising:
at least one capacitor (61),
wherein the at least one capacitor (61) comprises:
a semiconductor substrate (101) comprising an outer well (103) having a first conductivity type;
a first well (111, 112, 113) in the outer well (103) and having a second conductivity type;
a second well (121) in the first well (111, 112, 113) and having the first conductivity type;
a first electrode (141) and a second electrode (142), at least portions of the first electrode (141) and the second electrode (142) contacting the second well (121);
a first choke impedance element (151) connected between the second well (121) and a ground voltage (GND); and
a second choke impedance element (152) connected between the first well (111, 112, 113) and a power supply voltage (VDD).
